# EUROPEAN PATENT SPECIFICATION

(11) **EP 2 704 224 B1**
(45) Date of publication and mention of the grant of the patent: **11.05.2016**
(21) Application number: 13182535.8
(22) Date of filing: 30.08.2013
(51) Int. Cl.: H01L 39/24, H01L 39/14

(54) **Method for producing oxide superconductor**
Verfahren zur Herstellung eines Oxid-Supraleiters
Procédé de production d'un oxyde supraconducteur

(30) Priority: 31.08.2012 JP 2012190763
(43) Date of publication of application: 05.03.2014
(73) Proprietor: Kabushiki Kaisha Toshiba, Tokyo 105-8001 (JP)
(72) Inventor: Araki, Takeshi, Tokyo 105-8001 (JP); Hayashi, Mariko, Tokyo 105-8001 (JP); Fuke, Hiroyuki, Tokyo 105-8001 (JP)
(74) Representative: Moreland, David

(56) References cited:
- JP-A- 2008 137 833
- US-A1- 2006 058 195

## Description

### FIELD

Embodiments described herein relate generally to a method for manufacturing an oxide superconductor.

### BACKGROUND

High temperature superconductor is a generic name for metal oxides having a superconducting transition temperature (T_{c}) higher than metal-based superconductor, whose T_{c} is theoretically considered to be 39 K or lower. Since 1986 when the first oxide superconductors were discovered, about 25 years have passed, and application thereof to large-sized facilities for which it is still considered advantageous to use superconductors even if cooling cost is included, such as superconducting power transmission cables, nuclear fusion reactors, magnetically levitated trains, particle accelerators and magnetic diagnostic equipment (MRI), has been realized.

Examples of oxide superconductors mainly include bismuth-based superconductors, yttrium-based superconductors, and mercury/thallium-based superconductors; however, most attraction has been paid in recent years to yttrium-based superconductors which exhibit the highest characteristics in a magnetic field at the liquid nitrogen temperature and do not necessitate noble metals.

Among the manufacturing methods for yttrium-based superconductors, a method that has rapidly extended its influence since around the year 2000 is a metal organic deposition (MOD) method using a trifluoroacetic acid salt, so-called a TFA-MOD (metal organic deposition using trifluoroacetates) method. (See for example JP2008-137833 and US2006/0058195). This manufacturing method is a technique by which an yttrium-based superconductor is grown in a liquid phase using fluorine, and thereby an orientation at the atomic level is obtained with high reproducibility. Furthermore, this technique not only does not require a vacuum apparatus, but also has a feature that since film formation and superconductivity formation are achieved separately, process control is easy, and a superconducting wire material is obtained in a stable mode.

The largest problem of the TFA-MOD method is an increase of film thickness. With 5617423-1-NJONES single coating technology, cracks are generated, and it is difficult to increase the film thickness. Therefore, for example, film thickness increasing that is achieved by repeated coating is under consideration. Furthermore, for example, film thickness increasing that is achieved by adding a crack preventing chemical is under consideration.

### BRIEF DESCRIPTION OF THE DRAWINGS

FIG. 1 is a flowchart illustrating an example of the preparation of a coating solution of a first embodiment;
FIG. 2 is a flow chart illustrating an example of the method for forming a film of a superconductor from the coating solution and the crack preventing chemical of the first embodiment;
FIG. 3A and FIG. 3B are photographs of the external appearance of a gel film of Example 1 obtained by adding CF₂H-(CF₂)₃-COOH;
FIG. 4A to FIG. 4C are photographs of the external appearance of a gel film of Example 1 obtained by adding CF₂H-(CF₂)₄-CF₂H;
FIG. 5 is a cross-sectional scanning electron microscopic (SEM) image of a gel film of Example 1 obtained by adding CF₂H-(CF₂)₃-COOH;
FIG. 6 is a Time-of-Flight Secondary Ion Mass Spectrometry (TOF-SIMS) image of the gel film of Example 1 obtained by adding CF₂H-(CF₂)₃-COOH;
FIG. 7 is a calcining profile of Example 1 and the like;
FIG. 8 is a cross-sectional SEM image of the gel film of Example 1 obtained by adding CF₂H-(CF₂)₄-CF₂H;
FIG. 9 is a firing profile of Example 4 and the like;
FIG. 10 is a cross-sectional transmission electron microscopic (TEM) observation image of the calcined film of Example 5 obtained by adding CF₂H-(CF₂)₃-COOH;
FIG. 11 is a cross-sectional TEM observation image of the calcined film of Example 5 obtained by adding CF₂H-(CF₂)₇-COOH;
FIG. 12 is a model diagram illustrating processes from film thickness increasing by using a crack preventing chemical to calcining;
FIG. 13 is a diagram illustrating the effect of the oxygen partial pressure at the time of calcining on the film thickness increasing;
FIG. 14 is an Energy-Dispersive X-ray Spectroscopic (EDS) map of the interior of a calcined film of a single coating deposition thick film of Example 7;
FIG. 15 is a diagram illustrating a crack generation model at the time of firing; and
FIG. 16 is a cross-sectional TEM image of the superconducting film of Example 16 having a thickness of 5.2 µm prepared by single coating deposition.

### DETAILED DESCRIPTION

High temperature superconductor is a generic name for metal oxides having a superconducting transition temperature (T_{c}) higher than metal-based superconductor, whose T_{c} is theoretically considered to be 39 K or lower. Since 1986 when the first oxide superconductors were discovered, about 25 years have passed, and application thereof to large-sized facilities for which it is still considered advantageous to use superconductors even if cooling cost is included, such as superconducting power transmission cables, nuclear fusion reactors, magnetically levitated trains, particle accelerators and magnetic diagnostic equipment (MRI), has been realized.

Examples of oxide superconductors mainly include bismuth-based superconductors, yttrium-based superconductors, and mercury/thallium-based superconductors; however, most attraction has been paid in recent years to yttrium-based superconductors which exhibit the highest characteristics in a magnetic field at the liquid nitrogen temperature and do not require noble metals. Bismuth-based superconducting wire materials, which are called the first generation superconductors, require silver in an amount of 60% by volume, and thus production withdrawal has occurred successively. Yttrium-based superconductors of the second generation are such that the sales volume of one contract exceeds the total length of wire materials of the superconductors of the first generation that are sold in 10 years or more, and thus there is an increasing expectation on the industrialized use of the superconductors of the second generation.

Mercury/thallium-based oxides have a T_{c} that is as high as 130 K or higher, but even if the oxides are cooled, the characteristics of the oxides do not improve, and when compared with yttrium-based oxides, the current density obtainable at the liquid nitrogen temperature is small, and there is a problem from the viewpoint of industrial usability. Furthermore, iron arsenic-based oxides that have been recently discovered have a T_{c} that is in the range of 60 K, and do not work in liquid nitrogen at about 60 K. There is a problem in terms of characteristics.

These yttrium-based superconductors are superconductors that are represented by the composition: YBa₂Cu₃O₇₋ₓ and have a perovskite structure, and oxides in which yttrium is substituted by rare earth elements of lanthanoid series (provided that some elements are excluded), also exhibit superconducting properties. Regarding the methods for manufacturing such superconductors, a pulse laser deposition method, a liquid phase growth deposition method, an electron beam (EB) method, a metal organic deposition (MOD) method and the like have been used so far.

Among these manufacturing methods, a method that has rapidly extended its influence since around the year 2000 is a metal organic deposition (MOD) method using a trifluoroacetic acid salt, so-called a TFA-MOD (metal organic deposition using trifluoroacetates) method. Traditional MOD methods involve solid phase growth without using fluorine, whereas this manufacturing method is a technique by which an yttrium-based superconductor is grown in a liquid phase using fluorine, and thereby an orientation at the atomic level is obtained with high reproducibility. This technique not only does not require a vacuum apparatus, but also has a feature that since film formation and superconductivity formation are achieved separately, process control is easy, and a superconducting wire material is obtained in a stable mode. Furthermore, this is an extraordinary technique that has been found for the first time in history, by which an orientation at the atomic level is obtained over a span of several hundred meters by liquid phase growth with high reproducibility, without using a vacuum system. Also, it is contemplated that since the method is a process capable of converting a wire material having a wide width into fine wires after baking, and thereby manufacturing the wire material in large quantities, this fact has led to a sales share of close to 100% on the basis of the contracts made as of the year 2012.

This technique finds its origin in a method for preparing a superconductor by an EB method (P.M. Mankiewich, et al., Appl. Phys. Lett. 51, (1987), 1753-1755), without involving BaCO₃, and an attempt made in the following year by Gupta et al. (A. Gupta, et al., Appl. Phys. Lett. 52, (1988), 2077-2079) to prepare a precursor such as the precursor of Mankiewich et al. by an inexpensive MOD method, was the first attempt to carry out the TFA-MOD method.

Because the superconductor prepared by Gupta et al. had different groups of the starting raw materials, it is speculated that the superconductor was afflicted by precipitates or impurities that are believed to be caused by the difference of the Y, Ba, Cu salts in solubility, and the superconducting properties were merely not more than about 1/100 of the precursor of Mankiewich et al. Therefore, it is anticipated that a superconductor having poor characteristics was obtained, without an orientation texture at the atomic level caused by the intrinsic liquid phase growth exhibited by the TFA-MOD method being realized.

In order to address the difference in solubility, McIntyre et al from Professor Cima's Group in MIT (P.C. McIntyre, et al. J. Appl. Phys. 71, (1992), 1868-1877) unified the raw materials into acetates. Thereby, a superconductor having characteristics that were almost equal to those of the superconductor of Mankiewich et al. could be obtained. Thereafter, a report was published in 1998 by Smith et al. from Professor Cima's Group that a film thickness of 1 µm could be achieved, while the details of the content of the report were not clearly known (J. A. Smith, et al. IEEE Trans. on Appl. Supercond., 9, (1999), 1531-1534), and thus active research has been made on the TFA-MOD method since around the year 1999.

The biggest drawback of the TFA-MOD method is that it has been believed that single coating technology cannot make a thick film. Superconducting wire materials are such that the superconducting critical current value in the presence of liquid nitrogen is important, and since an increase in film thickness leads to low cost, development has been actively carried out. In regard to the film thickness increasing of superconductors, Smith et al. as described above reported that the film thickness increased by process control, but the critical film thickness obtained in additional tests carried out using a high purity solution was 0.30 µm to 0.35 µm. The critical film thickness is the maximum film thickness obtainable by an optimal process, and the explanation that a thick film was realized only by a change in the process is quite inconsistent. In regard to the experiment by Smith et al., a possibility is assumed that certain impurities had been incorporated, and the impurities were effective in preventing cracks, so that a film thickness of 1 µm could be realized.

The key to film thickness increasing in the TFA-MOD method lies in the technology for preventing cracks at the time of calcining during which the volume reduction ratio reaches up to 80% to 90%. The critical film thickness of a superconducting film that is formed from a high purity solution by the TFA-MOD method is only 0.30 µm, and in a 0.35-µm film, cracking may easily occur, and reproducibility is deteriorated.

In regard to this problem, Rupich et al. carried out film thickness increasing by using a crack preventing chemical primarily containing -(CH₂)ₙ-, in the disclosure made in 2000 (EP 1334525 B1). The technique of adding an organic substance having a hydrocarbon as the main chain was a common technique in traditional MOD methods.

However, when this technique is applied to the TFA-MOD method, it is speculated that problems occur in terms of the following points. Fluorine of a trifluoroacetate and hydrogen of-(CH₂)ₙ- may easily react with each other, and carbon atoms at the center are likely to remain as a result of the chemical reaction. Furthermore, it is speculated that Cu components that have small molecular weights, react at a low temperature and have a potential of sublimation, accumulate in the upper part of the film, and on the contrary, heavy Ba components accumulate in the lower part.

As the atomic weight of the metal element bonded to a trifluoroacetate group is smaller, the molecule can easily move about. For the purpose of preventing sublimation of copper trifluoroacetate which has the smallest molecular weight at the time of calcining, McIntyre et al. (P.C. McIntyre, et al., Mat. Soc. Symp. Proc. 1.69, (1990), 743-746) carried out formation of an oligomer by means of partial hydrolysis. In contrast, it is speculated that heavy Ba components are segregated in the lower part of the film, and this tendency is also exhibited in cross-sectional TEM images of some samples.

Since the TFA-MOD method forms a liquid phase at the time of firing, it is expected to solve the problem of segregation in the calcined film. However, it is speculated from various experiments that the liquid phase has low fluidity, and the travel distance is even less than 10 nm to 20 nm. This is the reason why a highly porous, calcined film that is obtainable by film thickness increasing by single coating technology, remains without being dissolved after the firing process for forming a liquid phase. For the formation of a quasi-liquid layer, it is necessary that three kinds of metal elements exist at predetermined concentrations. If segregation of the metal elements occurs to a large extent, a quasi-liquid phase itself is not formed at the time of firing, the perovskite structure of the superconductor is not produced, and the superconducting properties are deteriorated. Therefore, with the film thickness increasing method with -(CH₂)ₙ-, it is thought that the characteristics deteriorate at about 0.6 µm, and the characteristics become more unstable at 0.8 µm. If a small sample is used, desired characteristics may be obtained with a thick film, but realization of characteristics between two ends in a long tape which measures 500 m or 1,000 m is not likely to occur. It is because a decrease in characteristics at any one site in the middle leads to a decrease in characteristics of the entire tape.

In the technology by Rupich et al., it is contemplated that the upper limit of the film thickness that can generate superconductivity is 0.6 µm to 0.8 µm due to segregation. Accordingly, due to the need to further gain a higher current value, film thickness increasing by repeated coating technology has been developed. However, film thickness increasing by repeated coating technology had a different problem. There was a defect that since a gel film is formed on top of the first deposited layer, a second deposited layer is formed, and then a calcining heat treatment is carried out, the upper layer is subjected to thermal history to an extent equal to that of the lower layer, and the characteristics easily become unstable. Furthermore, the technology by Rupich et al. is also a technology having many characteristics deteriorating factors, such as that a non-homogeneous layer is formed at the interface between the first layer and the second layer, or nuclei that serve as the starting points of random growth at the time of firing are formed (M. Rupich, et al., Supercond. Sci. Technol 23 (2010) 014-015).

In regard to the film thickness increasing by repeated coating technology that has been attempted until August 2008, it is believed that there has been no report that wire materials each measuring more than 100 m are stably obtained in all groups of the TFA-MOD method including Japan, the United States and Europe, because of the reasons described above. It is because the problem of residual carbon, the problem of segregation of metal species, the problem of characteristics destabilization due to the thermal history of the lower layer at the time of repeated coating technology, the problem of random growth caused by interfacial ununiformity, and the like are the causes.

In regard to the problem that a crack preventing chemical internally induces a chemical reaction, and metal components are segregated, and the problem that the superconducting properties are deteriorated by residual carbon components, Araki conducted development of a film thickness increasing technique of using a crack preventing chemical which mainly contains -(CF₂)ₙ- (JP 4738322 B2 and US 7833941 B2). This technique is also a technology that has been developed on the basis of the carbon expulsion scheme (T. Araki, et al., IEEE Trans. on Appl. Supercond., 13, (2003), 2803-2808), which is a mechanism by which carbon is expelled at the time of the calcining of the TFA-MOD method. In the calcining of the TFA-MOD method, metal oxides are temporarily formed while combustion is avoided, and a portion of the oxygen atoms bonded to Y and Ba are substituted by F. Carbon components that are irrelevant to those reactions become materials having low boiling points, and are volatilized to be removed. This is the gist of the carbon expulsion mechanism. Similarly, increasing of film thickness using an organic material having a high fluorine ratio so that no residual carbon remains from the crack preventing chemical, constitutes Araki's technology of film thickness increasing by single coating technology.

The technology of film thickness increasing by single coating technology was rapidly popularized in the United States as well as in Europe after the presentation made by Araki et al. in an international conference in August 2008. In regard to the film thickness increasing by single coating deposition that is practiced in the United States, since there is no report on the particulars of the process, the details are not clearly known; however, there is a possibility that processes of film thickness increasing that are close to Araki's technology are being conducted. The technology of film thickness increasing by single coating deposition does not result in characteristics destabilization in wire materials caused by laminated interface destabilization as compared with the method of film thickness increasing by repeated coating deposition, and the calcining process which may be considered to require a treatment for a long time in the TFA-MOD method can be completed in one time. Accordingly, this technology is a technology that exhibits its power particularly in the case where it is intended to obtain a stable film having a thickness of more than 0.5 µm to 0.6 µm.

Araki's technology of film thickness increasing by single coating deposition published in 2006 realized for the first time in the world a single coating deposition film having a thickness of 1.3 µm as a superconducting film without cracks, and it is true that superconducting properties were obtained, though to a small extent. However, when it is attempted to form a film of a superconducting material having a thickness of 1.5 µm or 2.0 µm with that film thickness increasing technology, it was found that in order to perform film formation in a stable mode, special calcining conditions are required. Furthermore, the production of long wire materials require film formation by a continuous process, and a coating solution having a crack preventing chemical added thereto needs to exist stably for a long time. Since there are some crack preventing chemicals which cannot exist stably for a long time after being mixed with a solution, it was also found that there are materials which, although film formation therewith can be achieved with a small amount of a sample, are not suitable for continuous processes of maintaining a solution for a long time.

In a calcining process which does not involve a crack preventing chemical, because three kinds of trifluoroacetates are decomposed at temperatures relatively close to each other, a slow increase in temperature is required in order to prevent the generation of cracks due to stress concentration (T. Araki, et al., IEEE Trans. on Appl. Supercond., 13, (2003), 2803-2808). On the other hand, it was found that in the case where a crack preventing chemical has been added, when an increase in temperature is carried out slowly, since CuO undergoes grain growth, stress is accumulated in the interior, and cracking may easily occur.

In the days of year 2006, calcining was carried out with the oxygen partial pressure fixed to 100%. However, depending on the calcining process, the crack preventing chemical may be combusted. Thus, it was also found that calcining in a 100% oxygen atmosphere is not necessarily effective.

The method for manufacturing an oxide superconductor of the embodiments includes dissolving fluorocarboxylic acid salts including trifluoroacetates, among which metals including yttrium and lanthanoid metals (provided that cerium, praseodymium, promethium, and ruthenium are excluded), barium and copper are mixed; preparing a coating solution containing alcohols including methanol as a solvent; adding CF₂H-(CF₂)ₙ-COOH or HOCO-(CF₂)ₘ-COOH (wherein n and m represent positive integers) as a crack preventing chemical to the coating solution; forming a gel film on a substrate using the coating solution having the crack preventing chemical added thereto; subjecting the gel film to calcining at an oxygen partial pressure of 3% or less in a process that is maintained at 200°C or higher for a total time of 7 hours or less; forming a calcined film; and subjecting the calcined film to firing and oxygen anneal to form a film of an oxide superconductor.

The embodiments relate to a method for manufacturing an oxide superconductor which is used in superconducting power transmission cables, superconducting coils, superconducting magnets, magnetic resonance imaging (MRI) apparatuses, magnetically levitated trains, superconducting magnetic energy storage (SMES), and the like.

The embodiments are intended to provide solutions such as presented below in order to effectively realize stable film thickness increasing. The solutions are: (1) a crack preventing chemical that exists stably in a coating solution for the TFA-MOD method; (2) the reason why cracks are easily generated during the retention for a long time upon calcining, and countermeasures; and (3) the calcining conditions required for suppressing combustion of the crack preventing chemical.

According to the embodiments, there is provided a technique by which film formation is stably carried out in a continuous process, even in a state in which a coating head or a meniscus portion is in contact with a solution for a long time as in the case of die coating or web coating, and a thick film having a thickness which exceeds 1.5 µm with high reproducibility is obtained in an even more stable mode than the prior applications of Araki (JP 4738322 B2 and US 7833941 B2).

### (First embodiment)

The method for manufacturing an oxide superconductor of the present embodiment includes dissolving fluorocarboxylic acid salts including trifluoroacetates, among which metals including yttrium or lanthanoid metals (provided that cerium, praseodymium and promethium ruthenium are excluded), barium and copper are mixed at a ratio of approximately 1 : 2 : 3; preparing a coating solution containing alcohols including methanol as a solvent; adding CF₂H-(CF₂)ₙ-COOH or HOCO-(CF₂)ₘ-COOH (wherein n and m represent positive integers) as a crack preventing chemical to the coating solution; forming a gel film on a substrate using the coating solution having a crack preventing chemical added thereto; subjecting the gel film to calcining at an oxygen partial pressure of 3% or less in a process that is maintained at 200°C or higher for a total time of 7 hours or less; forming a calcined film; and subjecting the calcined film to firing and oxygen anneal to form a film of an oxide superconductor.

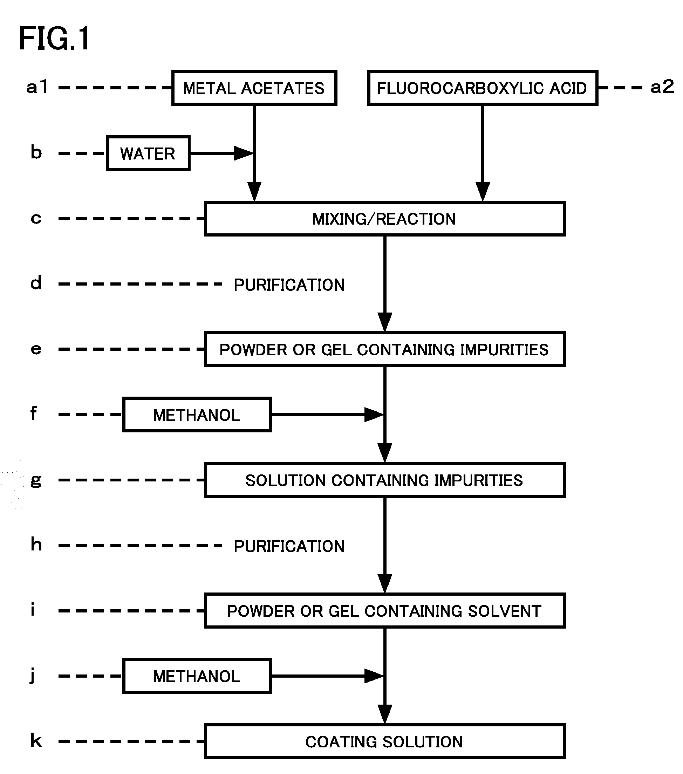

FIG. 1 is a flowchart illustrating an example of the preparation of a coating solution of the present embodiment.

In the production method of the present embodiment, first, fluorocarboxylic acid salts including trifluoroacetates, among which metals including yttrium or lanthanoid metals (provided that cerium, praseodymium, promethium, and ruthenium are excluded), barium and copper are mixed at an atomic ratio of approximately 1 : 2 : 3, are dissolved, and thus a coating solution containing alcohols including methanol as a solvent is prepared.

Specifically, as illustrated in FIG. 1, metal acetates, for example, the respective acetates of yttrium, barium and copper, are provided (a1). Furthermore, a fluorocarboxylic acid is provided (a2). Next, the provided metal acetates are dissolved in water (b), the solution is mixed with the provided fluorocarboxylic acid to react therewith (c). The solution thus obtained is purified (d), and thus a powder (sol) or gel containing impurities is obtained (e). Thereafter, the sol or gel thus obtained is dissolved in methanol (f), and thus a solution containing impurities is prepared (g). The solution thus obtained is purified to eliminate impurities (h), and a powder (sol) or a gel containing a solvent is obtained (i). Furthermore, the sol or gel thus obtained is dissolved in methanol (j), and thus a coating solution is provided (k).

Meanwhile, the term "atomic ratio of approximately 1 : 2 : 3" is a concept which is not limited to the case where the atomic ratio is perfectly 1 : 2 : 3, but allows a slight deviation. A slight deviation is attributable to, for example, the purity of the acetates or the amount of water of crystallization, and thus, the "atomic ratio of approximately 1 : 2 : 3" is a concept which allows a deviation in the atomic ratio of about 5% from 1 : 2 : 3 at the time of raw material mixing. Meanwhile, this composition indicates amounts that do not contain, for example, dopes such as Dy₂O₃ particles, which are aimed for an enhancement of superconducting properties in a magnetic field.

It is desirable that the fluorocarboxylic acid salts include trifluoroacetates at a proportion of 70 mol% or more. In order to bring about a liquid phase reaction at the time of firing, which is characteristic in the TFA-MOD method, fluorocarboxylic acid is required; however, a fluorocarboxylic acid having the smallest number of carbon atoms is trifluoroacetic acid. Even in the case where pentafluoropropionic acid having one more carbon atom is used in a portion, an increase in the amount of residual carbon occurs, and carbon components diffuse in the form of CO or CO₂ at the CuO surface of a YBa₂Cu₃O₇₋ₓ superconductor, so that the superconducting properties deteriorate. Therefore, the proportion of trifluoroacetic acid is desirably 70 mol% or more.

Furthermore, it is desirable that the solvent include methanol at a proportion of 80 mol% or more. The most volatile compound among alcohol-based organic solvents is methanol. Film formation can still be achieved even if other alcohols are incorporated in a small amount, but if the proportion is 20 mol% or more, the amount of residual carbon components increases after film formation and baking, and superconducting properties deteriorate. Solvents other than methanol are allowed up to a proportion of 20 mol%, but the characteristics tend to slightly deteriorate.

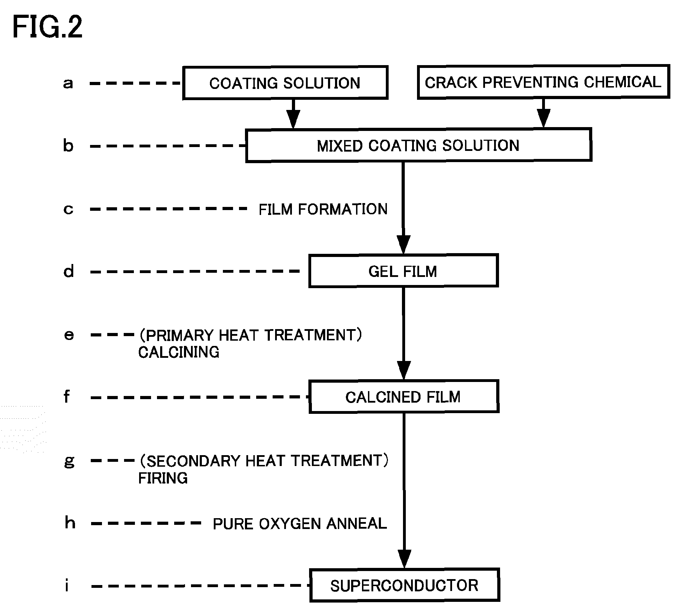

FIG. 2 is a flowchart illustrating an example of the method for forming a film of a superconductor from the coating solution and the crack preventing chemical of the present embodiment.

In the production method of the present embodiment, CF₂H-(CF₂)ₙ-COOH or HOCO-(CF₂)ₘ-COOH (wherein n and m represent positive integers) is added as a crack preventing chemical to the coating solution, and a gel film is formed on a substrate using the coating solution having a crack preventing chemical added thereto. The gel film is subjected to calcining at an oxygen partial pressure of 3% or less in a process that is maintained at 200°C or higher for a total time of 7 hours or less, a calcined film is formed, and the calcined film is subjected to firing and oxygen anneal to form a film of an oxide superconductor.

Specifically, as illustrated in FIG. 2, first, the coating solution previously prepared and a crack preventing chemical are provided (a). To the coating solution thus provided, the crack preventing chemical similarly provided is added, and thus a mixed coating solution containing a crack preventing chemical is prepared (b). Thereafter, a film is formed by applying the mixed coating solution on a substrate by, for example, a die coating method (c), and thus a gel film is obtained (d). Thereafter, the gel film thus obtained is subjected to calcining, which is a primary heat treatment, organic materials are decomposed (e), and thus a calcined film is obtained (f). Furthermore, this calcined film is subjected to firing, which is a secondary heat treatment (g), and subsequently to, for example, pure oxygen anneal (h), and thus a superconductor (i) is obtained.

The substrate is, for example, a LaAlO₃ single crystal substrate, but the substrate is not intended to be limited to this as long as a gel film can be formed thereon. A YSZ (yttrium oxide-reinforced zirconium oxide) substrate having a CeO₂ intermediate layer formed therein may be used, or a metal tape having a film of CeO₂/YSZ/Y₂O₃ formed thereon may also be used. At the time of forming a superconducting film, if the lattice constant of the superconducting film is concordant with that of an intermediate layer which does not induce a chemical reaction, a superconducting film can be formed on top of the intermediate layer.

As the crack preventing chemical, CF₂H-(CF₂)ₙ-COOH or HOCO-(CF₂)ₘ-COOH (wherein n and m represent positive integers) is used. Particularly, a compound of the above formula in which n = 2 to 6 and m = 2 to 5, is desirable because a high crack preventing effect is obtained.

The crack preventing chemical to be added is preferably a perfluorocarboxylic acid which does not react with trifluoroacetic acid and undergoes less segregation when mixed with a similar strong acid. It is preferable if the proportion of perfluorocarboxylic acid in the crack preventing chemical that is added is 75 mol% or more, because a high crack preventing effect is obtained. It is because when a crack preventing chemical which does not exhibit strong acidity is used, separation of the crack preventing chemical and strongly acidic trifluoroacetates occurs within the solution, and the crack preventing effect is lost.

However, a perfluorocarboxylic acid that is not hydrogenated is such that the opposite side of the carboxylic acid groups is neutralized, and carboxyl groups surround metal elements and the like to form a micelle-like structure, and thus separation in the solution is promoted. Therefore, the crack preventing effect is deteriorated. Accordingly, a substance effective as a crack preventing chemical is a substance described by the chemical formula: CF₂H-(CF₂)ₙ-COOH or HOCO-(CF₂)ₘ-COOH. When these substances are added to the solution in an amount of 75 mol% or more of the crack preventing chemical, the crack preventing effect increases, which is desirable.

Regarding the amount of addition of the crack preventing chemical, an amount of 3 atm% to 25 atm% relative to the amount of substance of the trifluoroacetates is appropriate. If the amount is too small, the crack preventing effect is lost, and if the amount is too large, there is a risk that superconducting properties may deteriorate due to residual carbon.

The time taken from the addition of the crack preventing chemical to the completion of film formation is desirably a short time in a space where the amount of methanol vapor or the amount of water vapor is controlled. When film formation is carried out within one hour, stable film formation can be realized. However, in the case of forming a tape that is 1,000 m long, at a film forming rate of 1 m/min, a time of 16 hours and 40 minutes is required. Therefore, a crack preventing chemical which does not deteriorate the solution for a certain time after being mixed with the solution is needed.

The mixed coating solution prepared with a crack preventing chemical of the present embodiment is extremely stable. Even if the time taken from the addition of the crack preventing chemical to the formation of a gel film is 60 minutes or longer, or even 24 hours or longer, satisfactory film formation can be carried out. That is, even if the time from the preparation of the mixed coating solution in FIG. 2 (FIG. 2-b) to the film formation (FIG. 2-c) is 60 minutes or longer, or even 24 hours or longer, the mixed coating solution is stable, and film formation can be achieved.

Particularly, when a crack preventing chemical having a small number of carbon atoms is applied, even if the time taken from the addition of the crack preventing chemical to the formation of a gel film is 7 days or longer, or even 14 days or longer, satisfactory film formation can be carried out.

In the present embodiment, calcining is carried out such that the process is maintained at 200°C or higher for a total time of 7 hours or less. That is, the time of retention at 200°C or higher at the time of calcining is 7 hours or less in total.

A temperature that should be defined is the temperature at which copper trifluoroacetate is decomposed and CuO nanocrystallites are formed. This temperature is, more accurately, highly likely to be 210°C to 220°C, but the details are unknown. The retention time at that temperature or a higher temperature could be 6 hours or less in total; however, what is known at this time point is that satisfactory film formation can be achieved by maintaining the retention temperature at 200°C or higher for 7 hours or less.

In the thick calcined film obtainable by adding a crack preventing chemical, pores attributed to the crack preventing chemical are present. Bridge areas exist in the vicinity of the pores, but it was found that a large number of CuO nanocrystallites exist in the bridge areas, and these nanocrystallites undergo particulate growth along with the temperature retaining time, thereby stress increasing. When this stress reaches a certain level or higher, bridges are destroyed, and cracks are generated. Therefore, in the case of forming a thick calcined film, the temperature retention after CuO formation is desirably a time as short as possible.

On the other hand, the answer to what is the minimum time that requires heating at 200°C or higher is not clearly known at this time point. In the TFA-MOD method, it is necessary to decompose trifluoroacetates to obtain oxides, and to convert a portion thereof into fluorides. However, when a crack preventing chemical has been added, fluorination occurs even from that chemical substance, and the reaction is completed in a short time.

At least in the case where no crack preventing chemical is used, calcining of about 7 hours at the minimum was required (JP 4738322 B2 and US 7833941 B2); however, when a perfluorocarboxylic acid is used, calcining should be carried out for 7 hours at the maximum. As such, in a solution in which a crack preventing chemical is incorporated, the optimum calcining process changes to a large extent.

Furthermore, in the present embodiment, calcining is carried out at an oxygen partial pressure of 3% or less. For better film formation, the oxygen partial pressure is preferably 1% or less, and more preferably 0.3% or less. It is understood that the generation of cracks is suppressed by preventing vigorous combustion of the crack preventing chemical at a low oxygen level.

For the decomposition of the crack preventing chemical, oxygen is needed at the time of calcining. However, it is not clearly understood at this time point of what is the lower limit of the amount of oxygen. Thick films produced by single coating deposition are obtained even with a heat treatment at an oxygen concentration of 0.1 %, 0.01%, or 0.001%. A thick film is obtained even at an oxygen concentration of 0.0001%, but realization of an oxygen partial pressure of lower than that value is difficult to be experimented because the concentration of the residual oxygen component in the cylinder gas is about 0.2 ppm.

However, it is also understood that crack generation may become quite vigorous at a concentration of 30% or 10%, and it is also understood that it is difficult to obtain a thick film having a thickness of about 1.5 µm at this oxygen partial pressure level. At this time point, it is understood that an oriented superconducting film having a thickness of 5.2 µm and having pores remaining therein is obtained with a thick film that has been heat treated at an oxygen concentration of 1%. In this film, the plane orientation of the perovskite structure coincides with the substrate orientation up to the vicinity of the surface, and it has been confirmed that growth of the TFA-MOD method has been realized.

Furthermore, according to the present embodiment, there is provided a technique by which a thick calcined film without cracks is stably obtained by simultaneously realizing the selection of the crack preventing chemical, the oxygen concentration at the time of calcining, and the heat treatment conditions at the time of calcining. According to this technology, a film of an oxide superconductor having a film thickness of 5.2 µm and without any cracks can be realized by at least a single coating deposition.

### (Second embodiment)

The method for manufacturing an oxide superconductor of the present embodiment includes dissolving fluorocarboxylic acid salts including trifluoroacetates, among which metals including yttrium and lanthanoid metals (provided that cerium, praseodymium and promethium are excluded), barium and copper are mixed at a ratio of approximately 1 : 2 : 3; preparing a coating solution containing alcohols including methanol as a solvent; adding to the coating solution a substance of formula: CF₂H-(CF₂)ₙ-COOH or HOCO-(CF₂)ₘ-COOH (wherein n and m represent positive integers), in which at least one or more of H of the carboxylic acid group (-COOH) are substituted by Y, La, Nd, Sm, Eu, Gd, Tb, Dy, Ho, Er, Tm, Yb, Ba and Cu, as a crack preventing chemical; forming a gel film on a substrate using the coating solution having a crack preventing chemical added thereto; subjecting the gel film to calcining at an oxygen partial pressure of 3% or less in a process that is maintained at 200°C or higher for a total time of 7 hours or less; forming a calcined film; and subjecting the calcined film to firing and oxygen anneal to form a film of an oxide superconductor.

The present embodiment is the same as the first embodiment, except that a substance of formula: CF₂H-(CF₂)ₙ-COOH or HOCO-(CF₂)ₘ-COOH (wherein n and m are positive integers), in which at least one or more of H of the carboxylic acid group (-COOH) are substituted by Y, La, Nd, Sm, Eu, Gd, Tb, Dy, Ho, Er, Tm, Yb, Ba and Cu, is included in the crack preventing chemical. Therefore, description of matters that overlap with the first embodiment will not be repeated here.

The present embodiment uses a substance of formula: CF₂H-(CF₂)ₙ-COOH or HOCO-(CF₂)ₘ-COOH (wherein n and m represent positive integers), in which at least one or more of H of the carboxylic acid group (-COOH) are substituted by Y, La, Nd, Sm, Eu, Gd, Tb, Dy, Ho, Er, Tm, Yb, Ba and Cu, in the crack preventing chemical. This substance is a substance of formula: CF₂H-(CF₂)ₙ-COOH or HOCO-(CF₂)ₘ-COOH (wherein n and m represent positive integers), in which H of the carboxylic acid group (-COOH) is substituted by a metal element that constitutes a superconductor. This substance also functions as a crack preventing chemical.

This substance may be, for example, CuOCO-(CF₂)₂-COOCu in which hydrogen of HOCO-(CF₂)₂-COOH is substituted with copper, or may be CF₂H-(CF₂)₃-COOCu in which hydrogen of CF₂H-(CF₂)₃-COOH is substituted with copper.

When the amount of hydrogen in the crack preventing chemical is extremely small, there is a risk that the crack preventing effect may be lost. This can be avoided by adding an appropriate amount of a crack preventing chemical in which hydrogen is not substituted by a metal element.

For example, when an equimolar amount of HOCO-(CF₂)₂-COOH is added to CuOCO-(CF₂)₂-COOCu, the fluorine ratio can be adjusted to 80%, and the effect of preventing cracks can be increased. Furthermore, at the time of this mixing, HOCO-(CF₂)₂-COOCu is expected to be formed.

Therefore, in the present embodiment, in order to decrease the fluorine ratio or to increase the hydrogen ratio, it is preferable to further add CF₂H-(CF₂)ₙ-COOH or HOCO-(CF₂)ₘ-COOH as a crack preventing chemical to the coating solution.

Also in the present embodiment, similarly to the first embodiment, a thick calcined film without cracks is obtained in a stable mode. Then, a thick film of an oxide superconductor without cracks can be realized.

### EXAMPLES

### (Example 1)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 1 Cs-base (Example 1, Coating solution base) at 1.86 M in terms of metal ions was obtained.

A mixed coating solution 1Cs-A is obtained by adding CF₂H(CF₂)₃COOH to the coating solution 1 Cs-base as a crack preventing chemical in an amount of 15 wt% relative to the solute of trifluoroacetates. A mixed coating solution 1 Cs-B is obtained by adding CF₂H(CF₂)₄CF₂H to the coating solution 1 Cs-base as a crack preventing chemical in an amount of 15 wt% relative to the solute of trifluoroacetates.

The mixed coating solution 1 Cs-A was filled in each of 100-cc beakers to a depth of about 30 mm, and an oriented LaAlO₃ single crystal substrate that had been polished on both surfaces was immersed in the liquid. The single crystal substrate was immersed for 1 minute in an environment at an air temperature of 25°C and a relative humidity of 30 RH% to 45 RH%, and a single crystal was pulled up at a pull-up rate of 70 mm/sec. In this manner, six sheets of gel films, 1Cs-A-Gf-01 (Gel film sample No.01), 1Cs-A-Gf-02, 1Cs-A-Gf-03, 1Cs-A-Gf-04, 1Cs-A-Gf-05, and 1Cs-A-Gf-06, were respectively obtained. In the same manner, gel films 1Cs-B-Gf-01, 1Cs-B-Gf-02, 1Cs-B-Gf-03, 1Cs-B-Gf 04, 1Cs-B-Gf-05, and 1Cs-B-Gf-06 were also respectively obtained from 1 Cs-B.

All the gel films are such that films are formed on both surfaces immediately after film formation, but one of the surfaces is wiped out. Since the wiping is carried out in a dry state, a gel film is remained in a striated form. Thus, if a film in a striated form is observed in a magnified photograph of a gel film, it is due to this wiping. A gel film formed under these conditions has a thickness of 10 µm as a calculated value, and the calculated values obtained after calcining and firing are 2.0 µm and 1.0 µm, respectively.

Since a gel film has very strong hygroscopic properties, the gel film is deteriorated. For 1Cs-A-Gf-01, 1Cs-A-Gf-02, 1Cs-B-Gf-01 and 1Cs-B-Gf-02 observed as gel films, two sheets each are introduced into a Teflon (registered trademark)-based special container, which prevent moisture, the gas inside the container is sufficiently purged with dry oxygen gas, and then the gel films are introduced into the containers. Immediately after the introduction, the containers are covered with lids in order to prevent moisture absorption. The gel films are fixed to the plastic container with a double-sided tape so as to facilitate the observation.

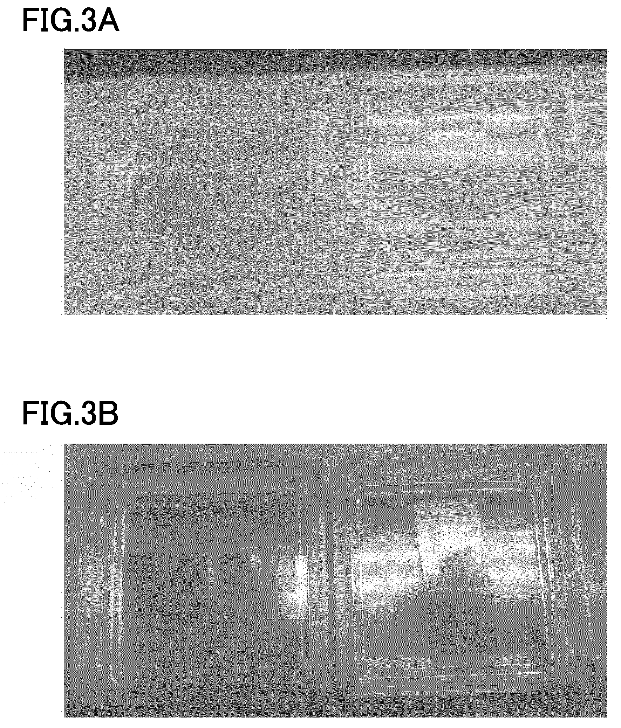

FIG. 3A and FIG. 3B are photographs of the external appearance of a gel film having a thickness of 10 µm, which has been subjected to film thickness increasing using CF₂H(CF₂)₃COOH as a crack preventing chemical. FIG. 3A is a photograph of the external appearance obtained immediately after (within 5 minutes) film formation, and FIG. 3B is a photograph of the external appearance obtained 96 hours after film formation. A thin blue gel film has been formed uniformly in both FIG. 3A and FIG. 3B.

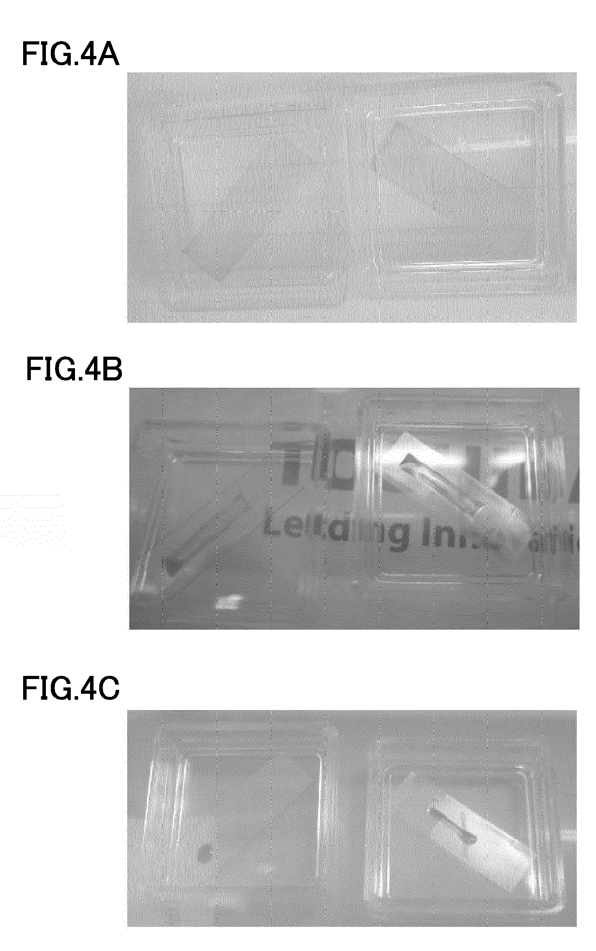

FIG. 4A to FIG. 4C are photographs of the external appearance of a gel film having a thickness of 10 µm, which has been subjected to film thickness increasing using CF₂H(CF₂)₄CF₂H as a crack preventing chemical. FIG. 4A is a photograph of the external appearance obtained immediately after (within 5 minutes) film formation, FIG. 4B is a photograph of the external appearance obtained 48 hours after film formation, and FIG. 4C is a photograph of the external appearance obtained 96 hours after film formation. FIG. 4A shows a thin blue gel film that has been formed uniformly over the entire surface. In FIG. 4B, the gel film is aggregated at the central area, and in FIG. 4C, the gel film is further aggregated.

Photographs of 1Cs-A-Gf-01 and 1Cs-A-Gf-02 obtained immediately after film formation are presented in FIG. 3A, and photographs of 1Cs-B-Gf-01 and 1Cs-B-Gf-02 obtained immediately after film formation are presented in FIG. 4A. Although the films appear slightly blurry because viewed over the container wall, it can be seen that all the gel films are thin and blue and are uniformly formed.

The environment in which the gel films are laid is at 25°C. The internal humidity is maintained to be 0% to 5%. 1Cs-B-Gf-01 and 1Cs-B-Gf-02 were such that both the two sheets tended to shrink at the time point when 48 hours had passed, and became similar to the films shown in FIG. 4B. The left section of FIG. 4A shows the film 1Cs-B-Gf-01. Furthermore, after 96 had passed, the films became similar to the films shown in FIG. 4C. On the other hand, 1Cs-A-Gf-01 and 1Cs-A-Gf-02 were such that after 96 hours had passed, the two sheets of FIG. 3B both had almost no change in the external appearance, and maintained thin blue gel films. No change was found in the gel films even after 240 hours.

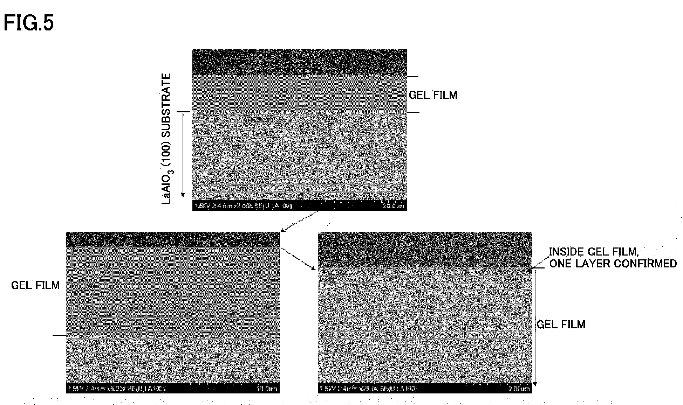

FIG. 5 shows cross-sectional SEM images of a gel film having a thickness of 10 µm, which is obtained by performing film thickness increasing using CF₂H(CF₂)₃COOH as a crack preventing chemical. FIG. 5 shows the results of performing a SEM observation of the gel film 1Cs-A-Gf-01 (left section of FIG. 3A) without exposing the gel film to an atmosphere having a humidity.

It was found that the gel film had a film thickness of about 10 µm, which was almost the same as the calculated value. Furthermore, a layer in a dry state was observed at the surface to the extent of about 3% by volume, which was believed to be because the film was maintained in a dry atmosphere for a long time period, but the remaining portion of the film was in a homogeneous state.

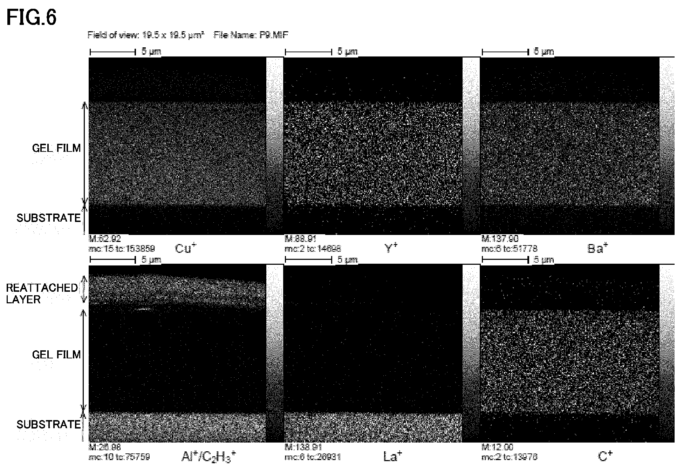

FIG. 6 shows TOF-SIMS images of FIG. 5. FIG. 6 shows the results obtained by performing an analysis of the gel film 1Cs-A-Gf-01 by TOF-SIMS.

No segregation was seen in the Y⁺, Ba⁺ and Cu⁺ components. It can be seen from the results of FIG. 6 that since the gel film is in a state before calcining, carbon components are also contained therein, but even those components are in a homogeneously mixed state. It was found that a homogeneous gel film is formed by film thickness increasing using CF₂H(CF₂)₃COOH as a crack preventing chemical.

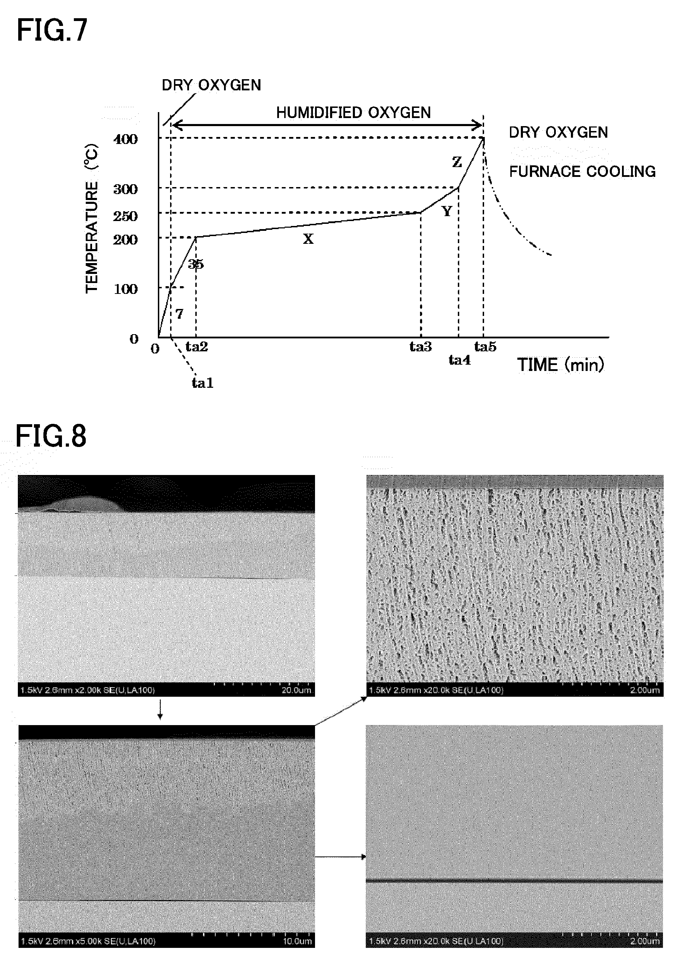

FIG. 7 is a calcining profile of the TFA-MOD method. The remaining gel films 1Cs-A-Gf-03, 1 Cs-A-Gf-04, 1Cs-A-Gf-05, 1Cs-A-Gf-06, 1Cs-B-Gf-03, 1Cs-B-Gf-04, 1Cs-B-Gf-05 and 1Cs-B-Gf-06 were subjected to a heat treatment by the calcining profile described in FIG. 7. In regard to the profile described in FIG. 7, a heat treatment was carried out by a profile of performing a heat treatment at 200°C to 250°C for a heat treatment time of 9 h 43 m, a heat treatment at 250°C to 300°C for a time of 1 h 40 m, and a heat treatment at 300°C to 400°C for a time of 0 h 20 m.

1Cs-A-Gf-03, 1 Cs-A-Gf-04, 1Cs-B-Gf-03, and 1Cs-B-Gf-04 were subjected to calcining in 10% oxygen gas, and 1Cs-A-Gf-05, 1Cs-A-Gf-06, 1Cs-B-Gf-05, and 1Cs-B-Gf-06 were subjected to calcining in 100% oxygen gas. As a result, calcined films without cracks could be obtained only from 1Cs-A-Gf-03 and 1 Cs-A-Gf-04.

CF₂H(CF₂)₃COOH and CF₂H(CF₂)₄CF₂H as crack preventing chemicals have almost the same molecular weights. Also, there is no significant difference in the fluorine ratio (proportion of fluorine atoms with respect to (fluorine atoms + hydrogen atoms)). The only difference between the two that can be thought of is whether the compound can co-exist with trifluoroacetates stably in a solution.

Trifluoroacetic acid has a structure in which the existence probability of electrons is shifted from the carboxyl group moiety to the CF₃⁻ side, so that hydrogen atoms or metal element atoms bonded thereto can be easily separated. The estimated pH of trifluoroacetic acid is about -0.6, and the acid exhibits very strong acidity while being an organic substance.

It is contemplated that since CF₂H(CF₂)₃COOH as a crack preventing chemical has the same structure, this compound can co-exist with the strong acid; however, since CF₂H(CF₂)₄CF₂H does not have the structure, this compound is separated in the solution. Therefore, it is contemplated that an unstable state is maintained even in a gel film, and as time passes, the interior of the film undergoes separation, so that results such as shown in FIG. 4A to FIG. 4C are obtained.

If film formation is carried out in a short time after a crack preventing chemical is incorporated into the coating solution, a gel film may be obtained; however, in a continuous process, a certain time passes between the process of addition of the crack preventing chemical to the coating solution and the process of film formation. It was found that in that case, CF₂H(CF₂)₄CF₂H is not suitable as a crack preventing chemical.

In order to investigate the reason why CF₂H(CF₂)₄CF₂H is not suitable as a crack preventing chemical, the difference between the relevant gel film and a gel film obtained using CF₂H(CF₂)₃COOH was investigated. 1Cs-A-Gf-07 and 1Cs-A-Gf-08, which were reproduction products of 1 Cs-A-Gf-01, were produced, and the gel films were placed in a bottle under a dry atmosphere so that deterioration would not occur, and were stored for 24 hours in a refrigerator (about 8°C) so as to prevent migration or deterioration. Before an analysis of the gel films was conducted, 1Cs-A-Gf-08 was stored for 7 days in a refrigerator. In this case, it was found that the gel films are maintained without migration as shown in FIG. 4A to FIG. 4C.

FIG. 8 is a cross-sectional SEM image of a gel film having a thickness of 10 µm, which is obtained by performing film thickness increasing using CF₂H(CF₂)₄CF₂H as a crack preventing chemical. For 1Cs-A-Gf-07, a cross-sectional SEM observation of the gel film was made immediately without storing. The results are shown in FIG. 8.

As is obvious from a comparison with FIG. 5, the gel film of FIG. 8 exhibits certain degeneration from the top to the central area, despite the short storage period and refrigerated storage that should lessen deterioration. It is not clearly understood at this point whether this degeneration is caused by the filler gas (pure oxygen) during storage, or it is such that although simple aggregation is expected to occur, as the substrate and the gel are closely adhered at the direct upper part of the substrate, aggregation is evaded by stress, and only the upper part is degenerated. It was found that even though a film appears sound in the external appearance, if a crack preventing chemical which does not comply with the present disclosure is used, segregation occurs inside the gel film.

### (Example 2)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 2Cs-base at 1.86 M in terms of metal ions was obtained.

The following substances were added as crack preventing chemicals to the coating solution 2Cs-base in an amount of 15 wt% with respect to the solute of trifluoroacetates. Coating solutions prepared by adding HOCO(CF₂)₂COOH, HOCO(CF₂)₃COOH, HOCO(CF₂)₄COOH, HOCO(CF₂)₅COOH, HOCO(CF₂)₆COOH, HOCO(CF₂)₇COOH, HOCO(CF₂)₈COOH, and HOCO(CF₂)₁₀COOH to 2Cs-base were referred to as 2Cs-PFDA-C04 (Example 2, Coating Solution, PerFluoroDioic Acid, number of Carbon atoms 04), 2Cs-PFDA-C05, 2Cs-PFDA-C06, 2Cs-PFDA-C07, 2Cs-PFDA-C08, 2Cs-PFDA-C09, 2Gs-PFDA-C10, and 2Cs-PFDA-C12, respectively.

Mixed coating solutions prepared by adding HOCO(CF₂)O(CF₂)₂O CF₂COOH and HOCO(CF₂)O(CF₂)O(CF₂)_{O} CF₂COOH to 2Cs-base were referred to as 2Cs-PFO-C06 (PerFluoro-3,6-diOxaoctane-1,8-dioic acid) and 2Cs-PFO-C08, respectively.

Mixed coating solutions prepared by adding CF₂H(CF₂)₂CF₂H, CF₂H(CF₂)₃CF₂H, CF₂H(CF₂)₄CF₂H, CF₂H(CF₂)₅CF₂H, CF₂H(CF₂)₆CF₂H, and CF₂H(CF₂)₈CF₂H to 2Cs-base were referred to as 2Cs-PFA-C04 (PerFluoro Alkane), 2Cs-PFA-C05, 2Cs-PFA-C06, 2Cs-PFA-C07, 2Cs-PFA-C08, and 2Cs-PFA-C10, respectively.

Mixed coating solutions prepared by adding CF₃(CF₂)₂COOH, CF₃(CF₂)₃COOH, CF₃(CF₂)₄COOH, CF₃(CF₂)₅COOH, CF₃(CF₂)₆COOH, CF₃(CF₂)₇COOH, CF₃(CF₂)₈COOH, and CF₃(CF₂)₉COOH to 2Cs-base were referred to as 2Cs-PFC-C04 (PerFluoro Carboxylic acid), 2Cs-PFC-C05, 2Cs-PFC-C06, 2Cs-PFC-C07, 2Cs-PFC-C08, 2Cs-PFC-C09, 2Cs-PFC-C10, and 2Cs-PFC-C11, respectively.

Mixed coating solutions prepared by adding CF₂H(CF₂)₂COOH, CF₂H(CF₂)₃COOH, CF₂H(CF₂)₄COOH, CF₂H(CF₂)₅COOH, CF₂H(CF₂)₆COOH, CF₂H(CF₂)₇COOH, CF₂H(CF₂)₆COOH, and CF₂H(CF₂)₉COOH to 2Cs-base were referred to as 2Cs-HPFC-C04 (5H-PerFluoro Carboxylic acid), 2Cs-HPFC-C05, 2Cs-HPFC-C06, 2Cs-HPFC-C07, 2Cs-HPFC-C08, 2Cs-HPFC-C09, 2Cs-HPFC-C10, and 2Cs-HPFC-C11, respectively.

All the mixed coating solutions described above having crack preventing chemicals added thereto, were each filled in a 100-cc beaker to a depth of about 30 mm, and an oriented LaAlO₃ single crystal substrate that had been polished on both surfaces was immersed in the liquid. A single crystal was pulled up at a pull-up rate of 70 mm/sec after 60 minutes from the mixing in the container in an environment at an air temperature of 25°C and a relative humidity of 30 RH% to 45 RH%, and one sheet of a gel film was obtained from each of the mixed coating solutions. For example, the gel film obtained from the mixed coating solution 2Cs-PFDA-C04 will be referred to as 2Gf-PFDA-C04.

All the gel films were subjected to a heat treatment by the calcining profile described in FIG. 7. In regard to the profile described in FIG. 7, a heat treatment was carried out by a profile of a heat treatment at 200°C to 250°C for a heat treatment time of 9 h 43 m, a heat treatment at 250°C to 300°C for a time of 1 h 40 m, and a heat treatment at 300°C to 400°C for a time of 0 h 20 m. The oxygen concentration was 10%, and the humidity was 4.2%. For example, the calcined film obtained from the gel film 2Gf-PFDA-C04 will be referred to as 2Cf-PFDA-C04.

Cracks were confirmed in 2Cf-PFO-C06, 2Cf-PFO-C08, 2Cf-PFA-C04, 2Cf-PFA-C05, 2Cf-PFA-C06, 2Cf-PFA-C07, 2Cf-PFA-C08, 2Cf-PFA-C10, 2Cf-PFC-C04, 2Cf-PFC-C05, 2Cf-PFC-C06, 2Cf-PFC-C07, 2Cf-1PFC-C08, 2Cf-PFC-C09, 2Cf-PFC-C10, and 2Cf-PFC-C11, while no cracks were generated in 2Cf-PFDA-C04, 2Cf-PFDA-C05, 2Cf-PFDA-C06, 2Cf-PFDA-C07, 2Cf-PFDA-C08, 2Cf-PFDA-C09, 2Cf-PFDA-C10, 2Cf-PFDA-C12, 2Cf-HPFC-C04, 2Cf-HPFC-C05, 2Cf-HPFC-C06, 2Cf-HPFC-C07, 2Cf-HPFC-C08, 2Cf-HPFC-C09, 2Cf-HPFC-C10, and 2Cf-HPFC-C11.

Regarding the film formation at the time of the prior applications of the inventors (JP 4738322 B2 and US 7833941 B2), crack preventing chemicals were added to all of the coating solutions, and film formation was carried out immediately thereafter. Thus, a crack preventing effect could be confirmed. However, this time, a standing time of 60 minutes intended to simulate continuous film formation was hallowed. It is speculated that this time caused separation and the like within the solution.

CF₂H(CF₂)₂CF₂H, CF₂H(CF₂)₃CF₂H, CF₂H(CF₂)₄CF₂H, CF₂H(CF₂)₅CF₂H, CF₂H(CF₂)₆CF₂H, and CF₂H(CF₂)₈CF₂H have a molecular structure in which hydrogen atoms at the two ends are positively charged, and fluorine atoms in the vicinity are negatively charged. Therefore, hydrogen bonding such as that in hydrogenated perfluorocarboxylic acid may be expected, but a crack preventing effect could not be confirmed.

Since these substances do not have fluorinated straight chains and carboxylic acid groups, the substances do not have properties associated with strong acid. Therefore, even if trifluoroacetates are incorporated, the system undergoes separation, and they are separated even from the system that does not exhibit a crack preventing effect. In order to allow a crack preventing effect to be exhibited stably, it is necessary for a crack preventing chemical to simultaneously have a fluorinated straight chain and a carboxyl group, which constitutes a structure exhibiting strong acidity.

HOCO(CF₂)O(CF₂)₂O CF₂COOH and HOCO(CF₂)O(CF₂)O(CF₂)₂O CF₂COOH have a fluorinated straight chain and a carboxylic acid group, and therefore, uniform mixing with trifluoroacetates can be expected. However, according to experimental results, cracks have been generated quite vigorously, and the product is cracked into a powder form.

In the straight chains of these substances, fluorine and oxygen co-exist, and there is a difference in electronegativity. It is speculated that at the time of calcining, the relevant part is subjected to an attack by trifluoroacetates and metal salts that are positively charged, the straight chain is divided, and a crack preventing ability is lost. Therefore, in order to exhibit a crack preventing effect, it is contemplated that not a structure having oxygen atoms inserted in a straight chain, but a structure having carbon atoms continuously in a straight chain is desirable.

CF₃(CF₂)₂COOH, CF₃(CF₂)₃COOH, CF₃(CF₂)₄COOH, CF₃(CF₂)₅COOH, CF₃(CF₂)₆COOH, CF₃(CF₂)₇COOH, CF₃(CF₂)₈COOH and CF₃(CF₂)₉COOH satisfy the two conditions described above, but cracks have been generated. In this regard, the existence probability of electrons is taken away from the hydrogen of the carboxylic acid group, and thus the hydrogen atoms are positively charged. However, what is negatively charged is the fluorine atoms in the vicinity of the carboxylic acid group, and the straight chain that is in the opposite polarity with the carboxylic acid group becomes electrically neutral.

Therefore, it is contemplated that a crack preventing chemical surrounds negatively charged elements as in the case of micelles of a soap, and the crack preventing effect is lost. Particularly, it is contemplated that the effect has increased in this occasion in which the system has been left to stand for 60 minutes. Also, for the same reason, it is speculated that a substance that is hydrogenated at the ends has a crack preventing effect.

From the results of Example 2, a substance which exhibits a stable crack preventing effect needs to satisfy all the conditions displayed by the three families of substances that have generated cracks. There are only two families of such substances, which include CHF₂-(CF₂)ₙ-COOH and HOCO-(CF₂)ₘ-COOH.

### (Example 3)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 3Cs-base at 1.86 M in terms of metal ions was obtained.

The following substances were added as crack preventing chemicals to the coating solution 3Cs-base in an amount of 15 wt% with respect to the solute of trifluoroacetates. Coating solutions prepared by adding HOCO(CF₂)₂COOH, HOCO(CF₂)₃COOH, HOCO(CF₂)₄COOH, HOCO(CF₂)₅COOH, HOCO(CF₂)₆COOH, HOCO(CF₂)₇COOH, HOCO(CF₂)₈COOH, and HOCO(CF₂)₁₀COOH to 3Cs-base were referred to as 3Cs-PFDA-C04 (Example 2, Coating Solution, PerFIuoroDioic Acid, number of Carbon atoms 04), 3Cs-PFDA-C05, 3Cs-PFDA-C06, 3Cs-PFDA-C07, 3Cs-PFDA-C08, 3Cs-PFDA-C09, 3Cs-PFDA-C10, and 3Cs-PFDA-C12, respectively.

Mixed coating solutions prepared by adding CHF₂(CF₂)₂COOH, CHF₂(CF₂)₃COOH, CHF₂(CF₂)₄COOH, CHF₂(CF₂)₅COOH, CHF₂(CF₂)₆COOH, CHF₂(CF₂)₇COOH, CHF₂(CF₂)₈COOH, and CHF₂(CF₂)₉COOH to 3Cs-base were referred to as 3Cs-HPFC-C04 (5H-PerFluoro Carboxylic acid), 3Cs-HPFC-C05, 3Cs-HPFC-C06, 3Cs-HPFC-C07, 3Cs-HPFC-C08, 3Cs-HPFC-C09, 3Cs-HPFC-C10, and 3Cs-HPFC-C11, respectively.

All the coating solutions described above having crack preventing chemicals added thereto, were each filled in a 100-cc beaker to a depth of about 30 mm, and an oriented LaAlO₃ single crystal substrate that had been polished on both surfaces was immersed in the liquid. Single crystals were pulled up at a pull-up rate of 70 mm/sec after 3 hours, after 6 hours, after 1 day, after 3 days, after 7 days, and after 14 days, from the mixing of the solution in an environment at an air temperature of 25°C and a relative humidity of 30 RH% to 45 RH%, and one sheet of a gel film was obtained from each of the mixed coating solutions.

The gel films thus obtained were subjected to a heat treatment by the calcining profile described in FIG. 7. In regard to the profile described in FIG. 7, a heat treatment was carried out by a profile of a heat treatment at 200°C to 250°C for a heat treatment time of 9 h 43 m, a heat treatment at 250°C to 300°C for a time of 1 h 40 m, and a heat treatment at 300°C to 400°C for a time of 0 h 20 m. The oxygen concentration was 10%, and the humidity was 4.2%.

For example, calcined films obtained by performing film formation after 3 hours and after 1 day from the mixing of solutions using the solution 3Cs-PFDA-C04, will be indicated herein as 3Cf-PFDA-C04-3hour and 3Cf-PFDA-C04-1 day, respectively. The surface state of the calcined film thus obtained was investigated, and it was found that cracks had been generated in 3Cf-PFDA-C12-7day, 3Cf-PFDA-C09-14day, 3Cf-PFDA-C10-14day, 3Cf-PFDA-C12-14day, 3Cf-HPFC-C10-7day, 3Cf-HPFC-C11-7day, 3Cf-HPFC-C08-14day, 3Cf-HPFC-C09-14day, 3Cf-HPFC-C10-14day, and 3Cf-HPFC-C11-14day.

It was found that when a solution mixed with a crack preventing chemical having a long carbon chain is retained for a long time, cracks tend to be generated easily. However, it was found that for several days after the addition of such a crack preventing chemical, the solution is stably maintained, and film formation is enabled.

### (Example 4)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained. The gel or sol thus obtained is dissolved in methanol (FIG. 1-j), and the solution is diluted by using a measuring flask. Thus, a coating solution 4Cs-base at 1.86 M in terms of metal ions was obtained.

The following substances were added as crack preventing chemicals to the coating solution 4Cs-base in an amount of 15 wt% with respect to the solute of trifluoroacetates. Mixed coating solutions prepared by adding HOCO(CF₂)₂COOH, HOCO(CF₂)₃COOH, HOCO(CF₂)₄COOH, HOCO(CF₂)₅COOH, HOCO(CF₂)₆COOH, HOCO(CF₂)₇COOH, HOCO(CF₂)₈COOH, and HOCO(CF₂)₁₀COOH to 4Cs-base were referred to as 4Cs-PFDA-C04, 4Cs-PFDA-C05, 4Cs-PFDA-C06, 4Cs-PFDA-C07, 4Cs-PFDA-C08, 4Cs-PFDA-C09, 4Cs-PFDA-C10, and 4Cs-PFDA-C12, respectively.

Mixed coating solutions prepared by adding CHF₂(CF₂)₂COOH, CHF₂(CF₂)₃COOH, CHF₂(CF₂)₄COOH, CHF₂(CF₂)₅COOH, CHF₂(CF₂)₆COOH, CHF₂(CF₂)₇COOH, CHF₂(CF₂)₈COOH, and CHF₂(CF₂)₉COOH to 4Cs-base were referred to as 4Cs-HPFC-C04, 4Cs-HPFC-C05, 4Cs-HPFC-C06, 4Cs-HPFC-C07, 4Cs-HPFC-C08, 4Cs-HPFC-C09, 4Cs-HPFC-C10, and 4Cs-HPFC-C11, respectively.

All the coating solutions described above having crack preventing chemicals added thereto, were each filled in a 100-cc beaker to a depth of about 30 mm, and an oriented LaAlO₃ single crystal substrate that had been polished on both surfaces was immersed in the liquid. A single crystal was pulled up at a pull-up rate of 70 mm/sec after 2 hours from the mixing of the solution in an environment at an air temperature of 25°C and a relative humidity of 30 RH% to 45 RH%, and one sheet of a gel film was obtained from each of the mixed coating solutions.

The gel films thus obtained were subjected to a heat treatment by the calcining profile described in FIG. 7. In regard to the profile described in FIG. 7, a heat treatment was carried out by a profile of a heat treatment at 200°C to 250°C for a heat treatment time of 9 h 43 m, a heat treatment at 250°C to 300°C for a time of 1 h 40 m, and a heat treatment at 300°C to 400°C for a time of 0 h 20 m. The oxygen concentration was 10%, and the humidity was 4.2%. For example, the calcined film obtained using the solution 4Cs-PFDA-C04 will be referred herein to as 4Cf-PFDA-C04.

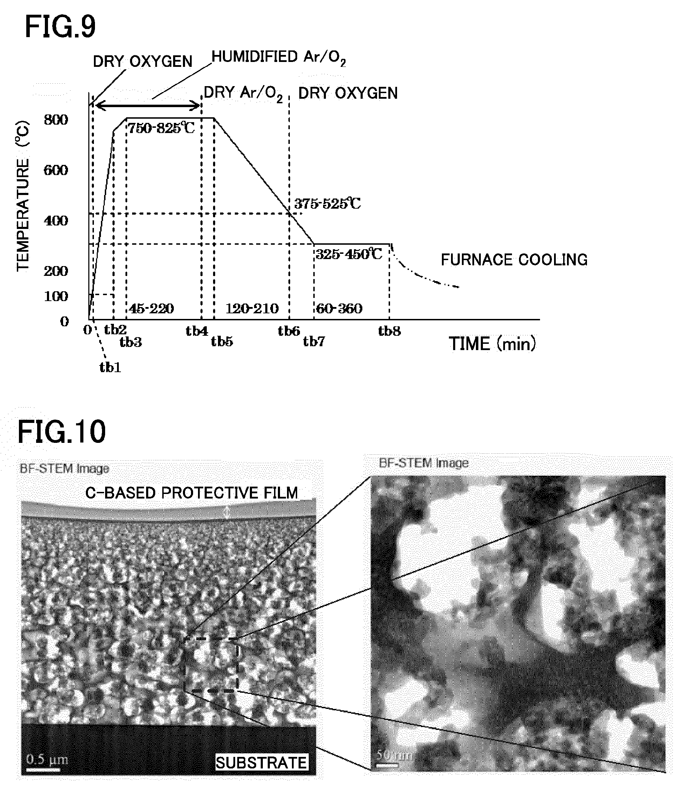

FIG. 9 is a firing profile of the TFA-MOD method. All the calcined films were subjected to baking by the firing profile shown in FIG. 9. Firing was carried out by retaining the calcined films at 800°C for 4 hours in argon gas mixed with 1,000 ppm of oxygen at a humidity of 4.2%, and subsequently, oxygen anneal was carried out at 525°C. Thus, respective superconductors were obtained.

A superconducting film obtainable by subjecting the calcined film 4Cf-PFDA-C04 to firing and oxygen anneal will be described as 4Ff-PFDA-C04 (Fired film). In this test, on a LaAlO₃ single crystal substrate, a thick film having a thickness of 1-µm grade has a problem of a/b axis-oriented grains. Although it is taken into consideration that there is a problem that the characteristics increase only by about 1 MA/cm² (77 K, 0 T), this test was carried out so that a decrease in the characteristics caused by residual carbon can be easily discriminated.

The superconducting properties were measured by an induction method. It is a method of applying a magnetic field in liquid nitrogen, and estimating the critical current density from the signals produced when perfect diamagnetism is destroyed. The results are presented in Table 1.

**[Table 1]**

| Sample Number | Crack preventing chemical | J_{c} value (MA/cm², 77K, 0T) |
|---|---|---|
| 4Ff-PFDA-C04 | HOCO(CF₂)₂COOH | 1.2 |
| 4Ff-PFDA-C05 | HOCO(CF₂)₃COOH | 1.1 |
| 4Ff-PFDA-C06 | HOCO(CF₂)₄COOH | 1.3 |
| 4Ff-PFDA-C07 | HOCO(CF₂)₅COOH | 1.1 |
| 4Ff-PFDA-C08 | HOCO(CF₂)₆COOH | 0.8 |
| 4Ff-PFDA-C09 | HOCO(CF₂)₇COOH | 0.6 |
| 4Ff-PFDA-C10 | HOCO(CF₂)₈COOH | 0.3 |
| 4Ff-PFDA-C12 | HOCO(CF₂)₁₀COOH | 0.4 |
| 4Ff-HPFC-C04 | CHF₂(CF₂)₂COOH | 1.2 |
| 4Ff-HPFC-C05 | CHF₂(CF₂)₃COOH | 1.3 |
| 4Ff-HPFC-C06 | CHF₂(CF₂)₄COOH | 1.2 |
| 4Ff-HPFC-C07 | CHF₂(CF₂)₅COOH | 1.4 |
| 4Ff-HPFC-C08 | CHF₂(CF₂)₆COOH | 1.1 |
| 4Ff-HPFC-C09 | CHF₂(CF₂)₇COOH | 0.7 |
| 4Ff-HPFC-C10 | CHF₂(CF₂)₈COOH | 0.4 |
| 4Ff-HPFC-C11 | CHF₂(CF₂)₉COOH | 0.2 |

It was found that if the number of carbon atoms is less than or equal to a certain value, characteristics are easily obtained; however, if the number of carbon atoms is greater than or equal to a certain value, the characteristics deteriorated. This is speculated to be because deterioration of superconducting properties caused by residual carbon has occurred.

It can be seen that CHF₂(CF₂)ₙCOOH and HOCO(CF₂)ₘCOOH each have a crack preventing effect. However, it was found that when the maintenance of superconducting properties is taken into consideration, n = 2, 3, 4, 5 and 6, and m = 2, 3, 4 or 5 are more preferred.

### (Example 5)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or so! (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 5Cs-base at 1.86 M in terms of metal ions was obtained.

CF₂H(CF₂)₃COOH and CF₂H(CF₂)₇COOH were added as crack preventing chemicals to the coating solution 5Cs-base in an amount of 15 wt% with respect to the solute of trifluoroacetates. The mixed coating solutions thus obtained were referred to as 5Cs-HPFC-C05 and 5Cs-HPFC-C09, respectively.

The mixed coating solutions 5Cs-HPFC-C05 and 5Cs-HPFC-C09 were each filled in a 100-cc beaker to a depth of about 30 mm, and an oriented LaAlO₃ single crystal substrate that had been polished on both surfaces was immersed in the liquid. A single crystal was pulled up at a pull-up rate of 70 mm/sec after 2 hours from the mixing of the solution in an environment at an air temperature of 25°C and a relative humidity of 30 RH% to 45 RH%, and one sheet of a gel film was obtained from each of the mixed coating solutions.

The gel films thus obtained were subjected to a heat treatment by the calcining profile described in FIG. 7. In regard to the profile described in FIG. 7, a heat treatment was carried out by a profile of a heat treatment at 200°C to 250°C for a heat treatment time of 9 h 43 m, a heat treatment at 250°C to 300°C for a time of 1 h 40 m, and a heat treatment at 300°C to 400°C for a time of 0 h 20 m. The oxygen concentration was 10%, and the humidity was 4.2%. The calcined films thus obtained were 5Cf-HPFC-C05 and 5Cf-HPFC-CO9.

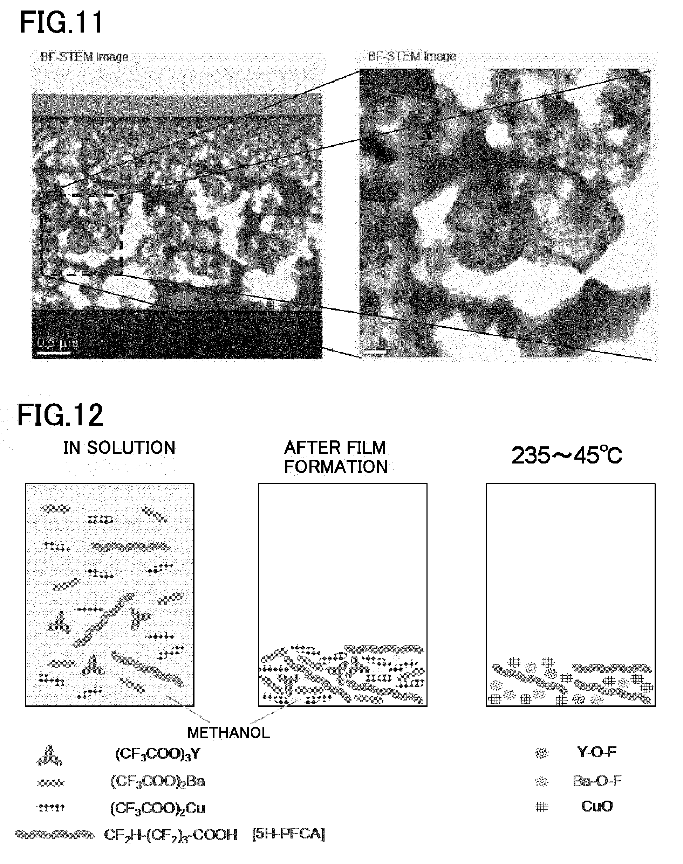

In order to perform an observation of the internal structure of the calcined films, a TEM observation was carried out. FIG. 10 shows a cross-sectional TEM observed image and a high magnification observed image of the calcined film that was subjected to film thickness increasing using CF₂H(CF₂)₃COOH as a crack preventing chemical. FIG. 11 shows a cross-sectional TEM observed image and a high magnification observed image of the calcined film that was subjected to film thickness increasing using CF₂H(CF₂)₇COOH as a crack preventing chemical.

FIG. 10 is such that the left section is an overview diagram, while the right section is a magnified diagram. It can be seen that although a LaAlO₃ single crystal substrate is laid below the film, the film has a highly porous structure in the vicinity of the substrate while the film surface is in a compact state. The calcined film of FIG. 10 would have a film thickness of about 2.0 µm, as calculated from the amount of substance, if the calcined film were a poreless calcined film which is perfectly compact. However, from the diagram, the film thickness was 3.2 µm. Therefore, when calculated from the amount of substance, it is speculated that pores occupy about 40% of the calcined film.

On the other hand, FIG. 11 also has a similar structure, and the film thickness in the external appearance is about 3.2 m. In this case, too, pores occupy 40% according to calculation. However, it can be seen that the space of the pores is quite large as compared with FIG. 10.

From the results of a thermal analysis of a trifluoroacetic acid methanol solution or the like, it is contemplated that decomposition of the solutes of a coating solution having a crack preventing chemical added thereto occurs in the following order as viewed in terms of temperature. The order follows copper trifluoroacetate, yttrium and barium trifluoroacetates, CF₂H(CF₂)₃COOH, and CF₂H(CF₂)₇COOH.

FIG. 12 is a model diagram illustrating, in order from the left side, a solution having a crack preventing chemical added thereto, a gel film formed from the solution, and the state in which only trifluoroacetates are decomposed at the time of calcining. It is speculated that the components are uniformly dissolved in the solution, while interacting with trifluoroacetates. After film formation, the film is in a state in which methanol has disappeared, and it is speculated that a film in a gel state is formed.

Immediately before the crack preventing chemical is decomposed, since trifluoroacetates have been decomposed, a system such as shown in the right-side diagram of FIG. 12 is obtained. At this time, there is a possibility that the crack preventing chemical may be in a liquid state, and it may be considered that the crack preventing chemical has a role of accelerating the aggregation of decomposed oxyfluorides. Therefore, it is contemplated that when all the trifluoroacetates are decomposed, and then the crack preventing chemical is decomposed at a temperature as close as possible to that temperature, aggregation, that is, coarsening of pores, is suppressed.

The crack preventing chemical that is considered to have a low decomposition temperature in this test is CF₂H(CF₂)₃COOH. From this reason, it is contemplated that a thick film obtained with CF₂H(CF₂)₇COOH has larger internal pores than a thick film obtainable with CF₂H(CF₂)₃COOH.

Even with these pores, the size of pores increases to the extent that the distance advances from the surface in the depth direction. It is believed that when the size of the pores reaches a critical value or higher, cracks are generated. Therefore, regarding the process of film thickness increasing with CF₂H(CF₂)₇COOH, which is considered to have a decomposition temperature that is further from the decomposition temperature of trifluoroacetates, it cannot be said that thick films are not at all obtainable, but it is contemplated that thick films are obtained more stably by the process of film thickness increasing using CF₂H(CF₂)₃COOH whose decomposition temperature is regarded to be closer to the decomposition temperature of trifluoroacetates.

### (Example 6)

It is thought that -(CF₂)ₙ- based crack preventing chemicals are decomposed and gasified at the time of calcining, and is thereby scattered and lost, with almost none remaining in the film. On the other hand, -(CH₂)ₙ- based crack preventing chemicals that have been actively developed by around year 2008 are thought to be such that after decomposition, tar-like carbon components remain within the superconducting material and significantly deteriorate the characteristics. Thus, although the crack preventing chemicals have similar structures, an enormous difference is resulted in superconducting films. Since decomposition of those crack preventing chemicals require oxygen, if the amount of the crack preventing chemicals is too large, combustion becomes vigorous, and if the amount is too small, it is feared that decomposition may occur insufficiently. In order to investigate this, the following experiment was carried out.

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved, When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 6Cs-base at 1.86 M in terms of metal ions was obtained.

CF₂H(CF₂)₃COOH was added as a crack preventing chemical to the coating solution 6Cs-base in an amount of 15 wt% with respect to the solute of trifluoroacetates, and a mixed coating solution 6Cs-HPFC-C05 was obtained.

The coating solution 6Cs-HPFC-C05 was filled in each of 100-cc beakers to a depth of about 30 mm, and oriented LaAlO₃ single crystal substrates that had been polished on both surfaces were immersed in the liquid. Substrates were pulled up at pull-up rates of 14 mm/sec, 40 mm/sec, 70 mm/sec or 100 mm/sec after 2 hours from the mixing of the solution in an environment at an air temperature of 25°C and a relative humidity of 30 RH% to 45 RH%, and four sheets each of the gel films were obtained. The gel films will be referred to as 6Gf-HPFC-C05-w014 (withdrawal speed: 014 mm/sec), 6Gf-HPFC-C05-w040, 6Gf-HPFC-C05-w070, and 6Gf-HPFC-C05-w100, respectively.

The gel films thus obtained were grouped into groups of 4 sheets each and were subjected to a heat treatment by the calcining profile described in FIG. 7. In regard to the profile described in FIG. 7, a heat treatment was carried out by a profile of performing a heat treatment at 200°C to 250°C for a heat treatment time of 9 h 43 m, a heat treatment at 250°C to 300°C for a time of 1 h 40 m, and a heat treatment at 300°C to 400°C for a time of 0 h 20 m. The oxygen concentration was set at 0.001%, 0.01%, 0.1%, 0.3%, 1%, 3%, 10%, and 100%. The humidity was 4.2%.

If the calcined film thus obtained is obtained using the gel film 6Gf-HPFC-C05-w040 at an oxygen partial pressure of 1%, the calcined film is a calcined film 6Cf-HPFC-C05-w040-1%, When the gel films obtained under these conditions at pull-up rates of 14 mm/sec, 40 mm/sec, 70 mm/sec and 100 mm/sec are subjected to firing, the theoretical film thicknesses with the porosity being assumed to be zero were 510 nm, 760 nm, 1,000 nm, and 1,190 nm, respectively, as superconducting films.

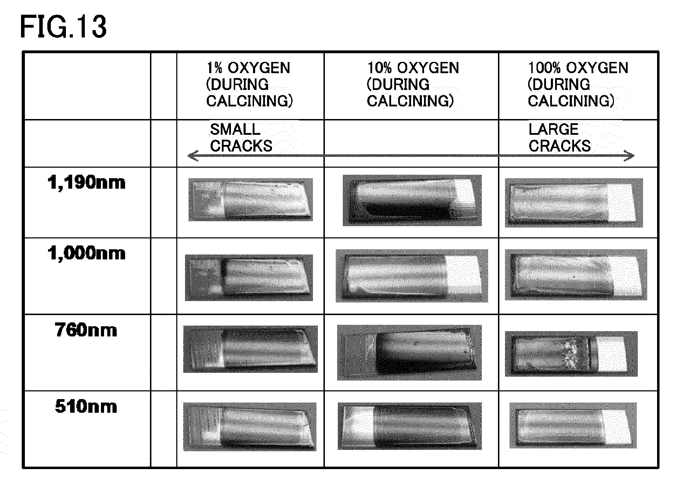

FIG. 13 is a table diagram showing the results of investigating how the external appearance of calcined films of superconducting films having film thicknesses of 510 nm to 1190 nm after firing (the estimated film thickness is assumed to be about 3 times the thickness obtainable after firing), is changed by the oxygen partial pressure at the time of calcining. FIG. 13 is photographs of the external appearance of 6Cf-HPFC-C05-w014-1%, 6Cf-HPFC-C05-w040-1%, 6Cf-HPFC-C05-w070-1%, 6Cf-HPFC-C05-w100-1%, 6Cf-HPFC-C05-w014-10%, 6Cf-HPFC-C05-w040-10%, 6Cf-HPFC-CO5-w070-10%, 6Cf-HPFC-C05-w100-10%, 6Cf-HPFC-C05-w014-10%, 6Cf-HPFC-C05-w040-100%, 6Cf-HPFC-C05-w070-100%, and 6Cf-HPFC-C05-w100-100%.

As can be seen from FiG. 13, it was found that when calcining is carried out in a 100% oxygen atmosphere, fluctuations or cracks are likely to occur at the film surface. It is not that a film having no cracks cannot be obtained in a 10% oxygen atmosphere, but as it can be seen even from a site where cracks have been generated in the liquid reservoir part in the lower part of the substrate, a slightly unstable external appearance is obtained. Although it is not shown in FIG. 13, stable film formation can be achieved at an oxygen partial pressure of 3% or less, and starting from calcining in a 1% oxygen atmosphere shown in FIG. 13, films without cracks have also been obtained even at oxygen concentrations of 0.0001%, 0.001%, 0.01%, 0.1 %, and 0.3%. The cylinder gas or line gas of argon used in this test guarantees only up to a concentration of 99.9999%, and an oxygen partial pressure of 0.0001% or less cannot be controlled.

It was found that in order to obtain a film having a thickness of 1 µm or greater stably by film thickness increasing by single coating deposition, it is necessary to control the combustion of the crack preventing chemical, and it is desirable to employ an oxygen partial pressure of 3% or less. The lower limit of the amount of oxygen is not clearly known, but the effect of preventing crack generation was obtained even at an oxygen amount of 0.0001%.

### (Example 7)

A cross-sectional TEM observation was carried out for the calcined films 5Cf-HPFC-C05 and 5Cf-HPFC-C09 obtained in Example 5, but in order to investigate whether there would be any change in the reaction occurring during the calcining of the TFA-MOD method when a crack preventing chemical is added, measurement of an EDS map was carried out.

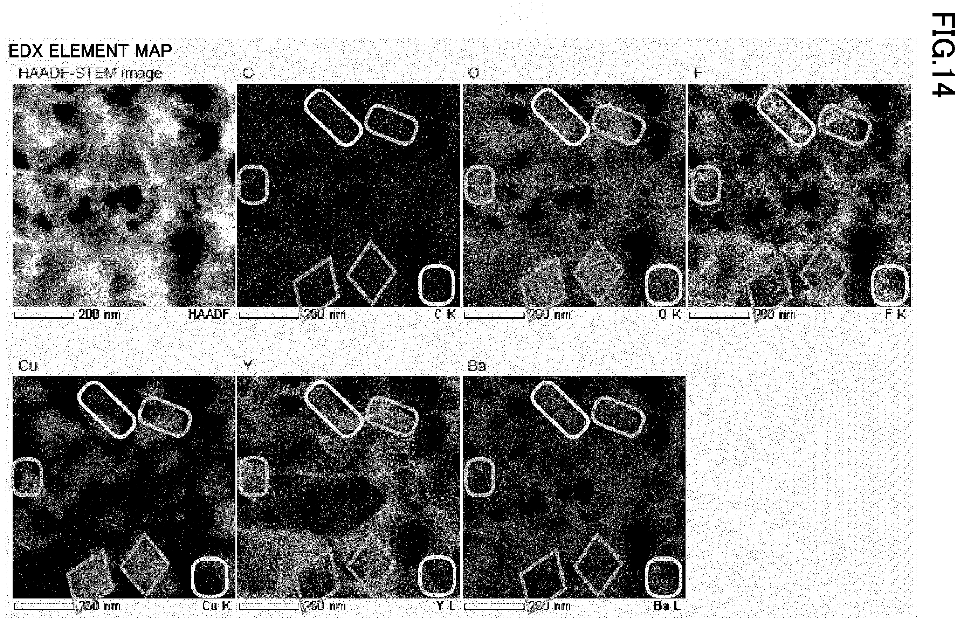

FIG. 14 shows the results obtained by carrying out film thickness increase after adding a crack preventing chemical, and carrying out the measurement of an EDS map when a cross-sectional TEM observation of a calcined film was carried out. It is an analysis carried out so as to investigate the difference in the reaction with a conventional TFA-MOD method on the basis of the presence or absence of the crack preventing chemical.

The EDS map af 5Cf-HPFC-C05 is presented in FIG. 14. In FIG. 14, a comparison was made between the existence ratios of elements at the sites indicated with borders, and it was found that CuO has been formed, that Ba-O-F is present in mixture in a state that cannot be said to be crystallized, and that a portion thereof is co-present with Y-O-F. It was also found that Y-O-F is distributed in a state close to amorphousness. Ba-O-F and Y-O-F may be considered as non-stoichiometric compounds, and it was found that these compounds do not undergo obvious grain growth.

On the other hand, it was also found that CuO undergoes grain growth and is coarsened as time passes. It was found that such a series of reactions are almost indifferent from the calcining reaction of the TFA-MOD method, and for film thickness increasing, even if CHF₂(CF₂)₃COOH is added, the calcining reaction of the TFA-MOD method is not much affected.

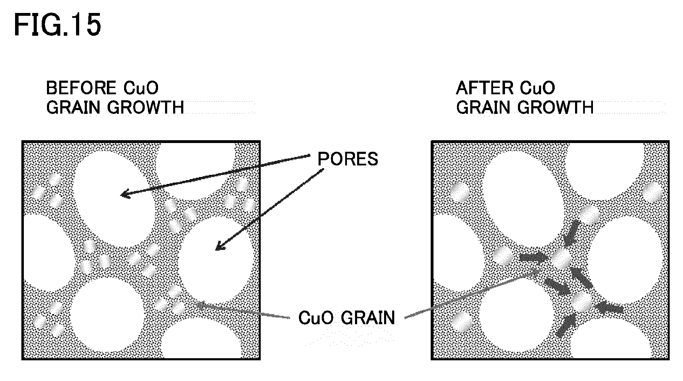

FIG. 15 is a model diagram illustrating that the stress caused by CuO grain growth at the bridge part of the calcined film obtained by a technology of film thickness increasing by single coating deposition, in which pores have been formed at the time of calcining, is causative of crack generation. To summarize the experimental facts obtained thus far, the model illustrated in FIG. 15 is believed to be a model of crack generation under retention at a high temperature for a long time at the time of film thickness increasing by single coating deposition.

First, when a crack preventing chemical that is needed for thickness film increasing by single coating deposition is added, due to the nature, pores are formed at the time of decomposition of the crack preventing chemical, as shown in FIG. 12. The periphery of the pores will be referred to as a bridge section. Even if a crack preventing chemical is added, the same reaction as that of the TFA-MOD Method, and therefore, CuO undergoes grain growth. Stress is applied to the bridge section due to CuO grain growth inside the bridge, and when the stress exceeds the limit of proof stress, cracks are generated. This is the model illustrated in FIG. 15.

The technology disclosed by this model, which is effective for film thickness increasing by single coating deposition, is not to retain the system at a temperature capable of CuO grain growth. Even if the generation of cracks involves aggregation of CuO grains, the limit of proof strength depends on the thickness of the bridge section (or the size of pores). Since the thickness itself of the bridge section also depends on the film pressure (pores become large at deep positions in a thick film), it cannot be generally said that cracks are generated at which size of pores. However, if the bridge section constantly has the same film thickness, the upper limit time for the destruction of the bridge section as a result of CuO grain growth will also be defined. It is understood from these results that there is an upper limit in the heat treatment time which generates no cracks in the film thickness increasing by single coating deposition.

### (Example 8)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 8Cs-base at 2.13 M in terms of metal ions was obtained.

CHF₂(CF₂)₃COOH was added as crack preventing chemicals to the coating solution 8Cs-base in an amount of 15 wt% with respect to the solute of trifluoroacetates. The mixed coating solution thus obtained was referred to as 8Cs-HPFC-C05.

The mixed coating solution 8Cs-HPFC-C05 was filled in a 100-cc beaker to a depth of about 30 mm, and an oriented LaAlO₃ single crystal substrate that had been polished on both surfaces was immersed in the liquid. A single crystal was pulled up at a pull-up rate of 100 mm/sec after 2 hours from the mixing of the solution in an environment at an air temperature of 25°C and a relative humidity of 30 RH% to 45 RH%, and a gel film 8Gf-HPFC-C05 was obtained.

The gel film thus obtained was subjected to a heat treatment by the calcining profile described in FIG. 7. In regard to the profile described in FIG. 7, a heat treatment was carried out by a profile of a heat treatment at 200°C to 250°C for a heat treatment time of 3 h 00 m to 12 h 00 m, a heat treatment at 250°C to 300°C for a time of 0 h 50 m, and a heat treatment at 300°C to 400°C for a time of 0 h 10 m. Some samples were subjected to the experiment by adjusting the times for heating at 250°C to 300°C and 300°C to 400°C to 2 times the original time or a half of the original time. The oxygen concentration was 1%, and the humidity was 4.2%.

The calcined film thus obtained would be named such that if the calcining time at 200°C to 250°C was set to, for example, 4.5 h, the calcined film was referred to as 8Cf-HPFC-C05-4.5h. Furthermore, when the calcined film is subjected up to firing under these conditions, the theoretical superconducting film thickness (film thickness with a porosity of zero) would be 1,500 nm. In addition to that, the same test was carried out also at a pull-up rate of 143 mm/sec or 195 mm/sec; however, it was thought that the process of dip coating had reached the limit, and because the rate at which the mixed coating solution ran down from the meniscus part under gravity was slow, a uniform gel film was not obtained.

The limit of the thickness of a uniform gel film obtainable by dip coating appears to be about 1,700 nm for a compact superconductor film, and in the case of forming a film that is thicker than that, die coating, web coating or the like is needed.

A list of the thermal decomposition temperatures at 200°C to 250°C and the presence or absence of cracks is summarized in Table 2.

**[Table 2]**

| | 200-250°C | 250-300°C | 300-400°C | Crack |
|---|---|---|---|---|
| 8Cf-HPFC-C05-3.0h | 3.0h | 0h50m | 0h10m | Absent |
| 8Cf-HPFC-C05-4.0h | 4.0h | 0h50m | 0h10m | Absent |
| 8Cf-HPFC-C05-4.5h | 4.5h | 0h50m | 0h10m | Absent |
| 8Cf-HPFC-C05-5.0h | 5.0h | 0h50m | 0h10m | Absent |
| 8Cf-HPFC-C05-6.0h | 6.0h | 0h50m | 0h10m | Absent |
| 8Cf-HPFC-C05-7.0h | 7.0h | 0h50m | 0h10m | Partial |
| 8Cf-HPFC-C05-8.0h | 8.0h | 0h50m | 0h10m | Present |
| 8Cf-HPFC-C05-9.0h | 9.0h | 0h50m | 0h10m | Present |
| 8Cf-HPFC-C05-10.0h | 10.0h | 0h50m | 0h10m | Present |
| 8Cf-HPFC-C05-12.0h | 12.0h | 0h50m | 0h10m | Present |
| 8Cf-HPFC-CO5-6.0h_2 | 6.0h | 1h40m | 0h20m | Present |
| 8Cf-HPFC-C05-6.0h_3 | 6.0h | 0h25m | 0h5m | Present |
| 8Cf-HPFC-C05-6.0h_4 | 6.0h | 1h40m | 0h10m | Present |

As can be seen from Table 2, it was found that if calcining for a total time of longer than 7 hours, that is, a retention time at 200°C to 250°C of longer than 6 hours, causes generation of cracks. It was found that for the formation of a film having a thickness of 1.5 µm, calcining for a total time of 7 hours or less is required. It is contemplated that this experimental fact provides data for fortifying the model of FIG. 15.

In addition, in regard to the present experiment, an experiment of adjusting the rate of temperature increase for the range of 250°C to 400°C to 2 times the original rate or a half of the original rate was also carried out, but cracks were generated. In the profile in which the temperature was increased in a short time, it is speculated that cracks were generated because the decomposition of the crack preventing chemical occurred insufficiently, and rapid combustion occurred. In the profile in which the temperature was increased in a long time, it is speculated that cracks were generated because CuO grain growth occurred.

### (Example 9)

A powder of each of the hydrates of Eu(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained was dissolved in methanol (FIG. 1-j, and the solution is diluted by using a measuring flask. Thus, a coating solution 9Eu-Cs-base (Eu-based coating solution) at 1.52 M in terms of metal ions was obtained.

CF₂H(CF₂)₃COOH was added as crack preventing chemicals to the coating solution 9Eu-Cs-base in an amount of 15 wt% with respect to the solute of trifluoroacetates. The mixed coating solution thus obtained was referred to as 9Eu-Cs-HPFC-C05.

The mixed coating solution 9Eu-Cs-HPFC-C05 was filled in a 100-cc beaker to a depth of about 30 mm, and an oriented LaAlO₃ single crystal substrate that had been polished on both surfaces was immersed in the liquid. A single crystal was pulled up at a pull-up rate of 100 mm/sec after 2 hours from the mixing of the solution in an environment at an air temperature of 25°C and a relative humidity of 30 RH% to 45 RH%, and a gel film 9Gf-HPFC-C05 was obtained.

The gel film thus obtained was subjected to a heat treatment by the calcining profile described in FIG. 7. In regard to the profile described in FIG. 7, a heat treatment was carried out by a profile of a heat treatment at 200°C to 250°C for a heat treatment time of 4 h 30 m, a heat treatment at 250°C to 300°C for a time of 0 h 50 m, and a heat treatment at 300°C to 400°C for a time of 0 h 10 m. The oxygen concentration was 1%, and the humidity was 4.2%. The calcined film thus obtained was referred to as 9Eu-Cf-HPFC-C05.

The calcined film 9Eu-Cf-HPFC-C05 was retained for 4 hours at a maximum temperature of 800°C in the firing profile illustrated in FIG. 8, and was subjected to oxygen anneal at a temperature of 525°C or lower and an amount of humidification of 4.2%. A superconducting film thus obtained was 9Eu-Ff-HPFC-C05.

By the technique such as described above, superconducting films 9Gd-Ff-HPFC-C05, 9Tb-Ff-HPFC-C05, 9Dy-Ff-HPFC-C05, 9Ho-Ff-HPFC-C05, 9Er-Ff-HPFC-C05, 9Tm-Ff-HPFC-C05, and 9Yb-Ff-HPFC-C05 were obtained using Gd(OCOCH₃)₃, Tb(OCOCH₃)₃, Dy(OCOCH₃)₃, Ho(OCOCH₃)₃, Er(OCOCH₃)₃, Tm(OCOCH₃)₃, and Yb(OCOCH₃)₃, respectively, in place of Eu(OCOCH₃)₃-

When the characteristics of these superconductors were measured by an induction method at 77K and 0 T, the characteristics were 1.2 MA/cm², 1.1 MA/cm², 1.3 MA/cm², 0.97 MA/cm², 0.75 MA/cm², 0.68 MA/cm², and 0.45 MA/cm² in this order. It was found that these superconductors can be subjected to film thickness increasing similarly to the case of a YBa₂Cu₃O₇₋ₓ superconductor. Furthermore, it is speculated that the characteristics were low because film formation was carried out on LaAlO₃ single crystal substrates, and a/b axis-oriented grains were formed.

### (Example 10)

A powder of Sm(OCOCH₃)₃ hydrate is dissolved in ion-exchanged water, and the solution is mixed with a reaction equimolar amount of CF₃CF₂COOH and stirred. Thus, a pale yellow solution is obtained. The mixed solution thus obtained is introduced into a pear-shaped flask and is subjected to reaction and purification for 12 hours in a rotary evaporator under reduced pressure. Thus, a semitransparent yellowish gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent yellowish gel or sol is obtained.

The gel or sol thus obtained was dissolved in methanol (FIG. 1-j), and the solution is diluted by using a measuring flask. Thus, a half coating solution 9Sm-h-Cs (Sm-based half coating solution) at 0.75 M to 1.30 M in terms of metal ions was obtained.

A powder of each of the hydrates of Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a transparent blue gel or sol is obtained.

The gel or sol thus obtained is dissolved in methanol (FIG. 1-j), and the solution is diluted by using a measuring flask. Thus, a half coating solution 9 Ba+Cu-h-Cs (Ba and Cu based half coating solution) at 1.52 M to 1.86 M in terms of metal ions was obtained.

9Sm-h-Cs and 9Ba+Cu-h-Cs were mixed such that the mixture would be at a metal ion molar ratio of Sm : Ba : Cu of 1 : 2 : 3, and thus a coating solution for Sm superconductor, 10Sm-Cs-base, at 1.15 M to 1.45 M in terms of metal ions was obtained.

CF₂H(CF₂)₃COOH was added as a crack preventing chemical to the coating solution 10Sm-Cs-base in an amount of 10 wt% with respect to the solute of trifluoroacetates. The mixed coating solution thus obtained was referred to as 10Sm-Cs-HPFC-C05.

The mixed coating solution 10Sm-Cs-HPFC-C05 was filled in a 100-cc beaker to a depth of about 30 mm, and an oriented LaAlO₃ single crystal substrate that had been polished on both surfaces was immersed in the liquid. A single crystal was pulled up at a pull-up rate of 45 mm/sec immediately after the mixing of the solution in an environment at an air temperature of 25°C and a relative humidity of 30 RH% to 45 RH%, and a gel film 10Sm-Gf-HPFC-C05 was obtained.

The gel film thus obtained was subjected to a heat treatment by the calcining profile described in FIG. 7. In regard to the profile described in FIG. 7, a heat treatment was carried out by a profile of a heat treatment at 200°C to 250°C for a heat treatment time of 6 h 00 m, a heat treatment at 250°C to 300°C for a time of 0 h 50 m, and a heat treatment at 300°C to 400°C for a time of 0 h 10 m. The oxygen concentration was 1%, and the humidity was 4.2%. The calcined film thus obtained was referred to as 10Sm-Cf-HPFC-C05.

The calcined film 10Sm-Cf-HPFC-C05 was retained for 2 hours at a maximum temperature of 800°C in the firing profile illustrated in FIG. 8 in the presence of a mixed argon gas at an oxygen partial pressure of 20 ppm, and was subjected to oxygen anneal at a temperature of 375°C or lower and an amount of humidification of 4.2%. A superconducting film thus obtained was 10Sm-Ff-HPFC-C05.

By the same technique as described above, superconducting films 10Nd-Ff-HPFC-C05 and 10La-Ff-HPFC-C05 were obtained using Nd(OCOCH₃)₃ and La(OCOCH₃)₃ instead of Sm(OCOCH₃)₃, and setting the oxygen partial pressure at the time of firing to 0.2 ppm to 5 ppm and the oxygen anneal initiation temperature to 325°C or lower. When the characteristics of the superconductors 10Sm-Ff-HPFC-C05 and 10Nd-Ff-HPFC-C05 were measured by an induction method at 77K and 0 T, the characteristics at a film thickness of 0.50 µm were 3.1 MA/cm² and 1.4 MA/cm², respectively. For 10La-Ff-HPFC-C05, peaks were confirmed by an XRD analysis. As described above, it was found that film thickness increasing can be achieved similarly to the case of the superconductor YBa₂Cu₃O₇₋ₓ,

### (Example 11)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 2.8, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained. The gel or sol thus obtained is dissolved in methanol (FIG. 1-j), and the solution is diluted by using a measuring flask. Thus, a half coating solution 11 Cs-half-A at 1.86 M in terms of metal ions was obtained.

In regard to the Cu component that was insufficient to obtain the 1 : 2 : 3 composition as described above, a powder of Cu(OCOCH₃)₂ hydrate was dissolved in ion-exchanged water, the solution was allowed to react with CF₂H(CF₂)₃COOH, and the reaction product was purified. Thereby, (CF₂H(CF₂)₃COO)₂Cu was obtained. This methanol solution was referred to as 11 Cs-half-B. 11 Cs-half-A and 11Cs-half-B were mixed, and a coating solution 11 Cs-base at a metal ion molar concentration of 1.52 M, in which the composition ratio of Y : Ba : Cu was 1 : 2 : 3, was obtained.

CF₂H(CF₂)₃COOH was added as a crack preventing chemical to the coating solution 11 Cs-base in an amount of 15 wt% with respect to the solute of trifluoroacetates. Furthermore, the amount of substance of CF₂H(CF₂)₃COOH was defined to be calculated to include the CF₂H(CF₂)₃COO⁻ group carried by (CF₂H(CF₂)₃COO)₂Cu. The mixed coating solution thus obtained was referred to as 11Cs-HPFC-C05.

The coating solution 11Cs-HPFC-C05 was filled in a 100-cc beaker to a depth of about 30 mm, and an oriented LaAlO₃ single crystal substrate that had been polished on both surfaces was immersed in the liquid. A single crystal was pulled up at a pull-up rate of 70 mm/sec after 2 hours from the mixing of the solution in an environment at an air temperature of 25°C and a relative humidity of 30 RH% to 45 RH%, and one sheet each of gel film was obtained.

The gel film thus obtained was subjected to a heat treatment by the calcining profile described in FIG. 7. In regard to the profile described in FIG. 7, a heat treatment was carried out by a profile of a heat treatment at 200°C to 250°C for a heat treatment time of 6 h 00 m, a heat treatment at 250°C to 300°C for a time of 0 h 50 m, and a heat treatment at 300°C to 400°C for a time of 0 h 10 m. The oxygen concentration was 1%, and the humidity was 4.2%. The calcined film thus obtained was referred to as 11Cf-HPFC-C05. It was found that also with this technique, cracks are prevented, and a thick film is obtained.

Formation of a thick film was carried out in the same manner as described above, except for changing the composition of 1 : 2 : 2.8 to 1 : 2 : 2.9, and a calcined film thus obtained was 11Cf-HPFC-C05-B. It was found that regarding this film, a thick film may be obtained while cracks are prevented.

### (Example 12)

Thick calcined films were formed in the same manner as in Example 11, except that Gd(OCOCH₃)₃ and Dy(OCOCH₃)₃ were used instead of Y(OCOCH₃)₃, and at a metal ion molar ratio of 1 : 2 : 2.8. The calcined films thus obtained were 12Gd-Cf-HPFC-C05 and 12Dy-Cf-HPFC-C05. It was found that also with this technique, a thick film may be obtained while cracks are prevented.

### (Example 13)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of a mixture of CF₃COOH and CF₃CF₂COOH, and stirred. The resulting mixtures are mixed together at a metal ion molar ratio of 1 : 2 : 3, and thus a mixed solution is obtained. For the mixture of CF₃COOH and CF₃CF₂COOH, three kinds of solutions having an amount of CF₃COOH, as an amount of substance, of 90%, 80%, and 70% were prepared. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-j) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution at 1.86 M in terms of metal ions was obtained. The solutions obtained using solutions having an amount of CF₃COOH of 90%, 80% and 70%, will be referred to as 13Cs-base-90%, 13Cs-base-80%, and 13Cs-base-70%, respectively.

CF₂H(CF₂)₃COOH was added as a crack preventing chemical to the respective coating solutions in an amount of 15 wt% with respect to the solute of trifluoroacetates, and mixed coating solutions 13Cs-HPFC-C05-90%, 13Cs-HPFC-C05-80%, and 13Cs-HPFC-C05-70% were obtained.

Each of the mixed coating solutions 13Cs-HPFC-C05-90%, 13Cs-HPFC-C05-80%, and 13Cs-HPFC-C05-70% was filled in a 100-cc beaker to a depth of about 30 mm, and an oriented LaAlO₃ single crystal substrate that had been polished on both surfaces was immersed in the liquid. The substrate was pulled up at a pull-up rate of 70 mm/sec after 2 hours from the mixing of the solution in an environment at an air temperature of 25°C and a relative humidity of 30 RH% to 45 RH%, and one sheet each of the gel films were obtained. The gel films were referred to as 13Gf-HPFC-C05-90%, 13Gf-HPFC-C05-80%, and 13Gf-HPFC-C05-70%, respectively.

The gel films thus obtained were subjected to a heat treatment by the calcining profile described in FIG. 7. In regard to the profile described in FIG. 7, a heat treatment was carried out by a profile of a heat treatment at 200°C to 250°C for a heat treatment time of 6 h 00 m, a heat treatment at 250°C to 300°C for a time of 0 h 50 m, and a heat treatment at 300°C to 400°C for a time of 0 h 10 m. The oxygen concentration was 1%, and the humidity was 4.2%. The calcined films thus obtained were referred to as 13Cf-HPFC-C05-90%, 13Cf-HPFC-C05-80%, and 13Cf HPFC-C05-70%, respectively. It was found that also with this technique, cracks are prevented, and thick films are obtained.

### (Example 14)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained was dissolved in methanol mixed with 10%, 20% or 30% of ethanol (FIG. 1-j), and the solution is diluted by using a measuring flask. Thus, coating solutions 14Cs-base-10%, 14Cs-base-20%, and 14Cs-base-30% at 1.86 M in terms of metal ions were obtained.

CF₂H(CF₂)₃COOH was added as a crack preventing chemical to the respective coating solutions 14Cs-base-10%, 14Cs-base-20%, and 14Cs-base-30% in an amount of 15 wt% with respect to the solute of trifluoroacetates. The mixed coating solutions thus obtained were referred to as 14Cs-HPFC-C05-10%, 14Cs-HPFC-C05-20%, and 14Cs-HPFC-CO5-30%, respectively.

Each of the mixed coating solutions 14Cs-HPFC-C05-10%, 14Cs-HPFC-CO5-20%, and 14Cs-HPFC-C05-30% was filled in a 100-cc beaker to a depth of about 30 mm, and an oriented LaAlO₃ single crystal substrate that had been polished on both surfaces was immersed in the liquid. A single crystal was pulled up at a pull-up rate of 70 mm/sec after 2 hours from the mixing of the solution in an environment at an air temperature of 25°C and a relative humidity of 30 RH% to 45 RH%, and one sheet each of the gel films were obtained.

The gel films thus obtained were subjected to a heat treatment by the calcining profile described in FIG. 7. In regard to the profile described in FIG. 7, a heat treatment was carried out by a profile of a heat treatment at 200°C to 250°C for a heat treatment time of 6 h 00 m, a heat treatment at 250°C to 300°C for a time of 0 h 50 m, and a heat treatment at 300°C to 400°C for a time of 0 h 10 m. The oxygen concentration was 1%, and the humidity was 4.2%. It was confirmed that regarding the calcined films thus obtained, 14Cf-HPFC-C05-10%, 14Cf-HPFC-C05-20%, and 14Cf-HPFC-CO5-30%, thick films without any cracks had been formed.

### (Example 15)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into two pear-shaped flasks and is subjected to reaction and purification for 12 hours in rotary evaporators under reduced pressure. Thus, a semitransparent blue gel or sol is obtained. The gel or sol in one of the pear-shaped flask is dissolved in methanol (FIG. 1-j), and the solution is diluted by using a measuring flask. Thus, a coating solution 15Cs-impure at 1.86 M in terms of metal ions was obtained.

Methanol in an amount corresponding to about 100 times the weight of the gel or sol (FIG. 1-f) is added to the gel or sol in the other flask, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 15Cs-pure at 1.86 M in terms of metal ions was obtained.

CF₂H(CF₂)₃COOH was added as a crack preventing chemical to the respective coating solutions 15Cs-impure and 15Cs-pure in an amount of 15 wt% with respect to the solute of trifluoroacetates. The mixed coating solutions thus obtained were referred to as 15Cs-HPFC-C05-impure and 15Cs-HPFC-C05-pure, respectively.

Each of the mixed coating solutions 15Cs-HPFC-C05-impure and 15Cs-HPFC-C05-pure was filled in a 100-cc beaker to a depth of about 30 mm, and an oriented LaAlO₃ single crystal substrate that had been polished on both surfaces was immersed in the liquid. A single crystal was pulled up at a pull-up rate of 70 mm/sec after 2 hours from the mixing of the solution in an environment at an air temperature of 25°C and a relative humidity of 30 RH% to 45 RH%, and one sheet each of the gel films were obtained.

The gel films thus obtained were subjected to a heat treatment by the calcining profile described in FIG. 7. In regard to the profile described in FIG. 7, a heat treatment was carried out by a profile of a heat treatment at 200°C to 250°C for a heat treatment time of 6 h 00 m, a heat treatment at 250°C to 300°C for a time of 0 h 50 m, and a heat treatment at 300°C to 400°C for a time of 0 h 10 m. The oxygen concentration was 1%, and the humidity was 4.2%. The calcined films thus obtained were referred to as 15Cf-HPFC-C05-impure and 15Cf-HPFC-C05-pure, respectively.

15Cf-HPFC-C05-pure was a thick film without cracks, whereas 15Cf-HPFC-C05-impure had severe cracks, and there were many exposed parts on the substrate. When a thick calcined film is formed using the technique of film thickness increasing by single coating deposition, porous sections are necessarily formed, and therefore, there is a problem with the strength in the bridge sections in the periphery. The impurities in the solution may be considered as different phase of acetic acid, Y, Ba or Cu. However, it is speculated that as those impurities move into the bridge sections and weaken the strength, even if film formation is carried out at a film thickness that is obtainable using a high purity solution, cracks propagate into those sections, and cracks are generated in the entire film or the like.

### (Example 16)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 16Cs-base at 1.52 M in terms of metal ions was obtained.

CF₂H(CF₂)₃COOH was added as a crack preventing chemical to the coating solution 16Cs-base in an amount of 15 wt% with respect to the solute of trifluoroacetates. A mixed coating solution thus obtained was referred to as 16Cs-HPFC-C05.

A gel film having a thickness of about 40 µm was formed on an oriented LaAlO₃ single crystal substrate that had been polished on both surfaces, using the principle of die coating with the mixed coating solution 16Cs-HPFC-C05. Film formation was carried out in an environment at an air temperature of 25°C and a relative humidity of 30 RH% to 45 RH%.

The gel film thus obtained was subjected to a heat treatment by the calcining profile described in FIG. 7. In regard to the profile described in FIG. 7, a heat treatment was carried out by a profile of a heat treatment at 200°C to 250°C for a heat treatment time of 6 h 00 m, a heat treatment at 250°C to 300°C for a time of 0 h 50 m, and a heat treatment at 300°C to 400°C for a time of 0 h 10 m. The oxygen concentration was 1%, and the humidity was 4.2%. The calcined film thus obtained was referred to as 16Cf-HPFC-C05. This film is considered to be a very thick calcined film without cracks, but since firing was carried out immediately after calcining, the film thickness as a calcined film is not known.

The calcined film 16Cf-HPFC-C05 was retained for 24 hours at a maximum temperature of 800°C in the firing profile illustrated in FIG. 9 in the presence of a mixed argon gas at an oxygen partial pressure of 1,000 ppm, and was subjected to oxygen anneal at a temperature of 525°C or lower and an amount of humidification of 1.26%. A superconducting film thus obtained was referred to as 16-Ff-HPFC-C05. The firing time was longer than necessary because the film thickness was not known.

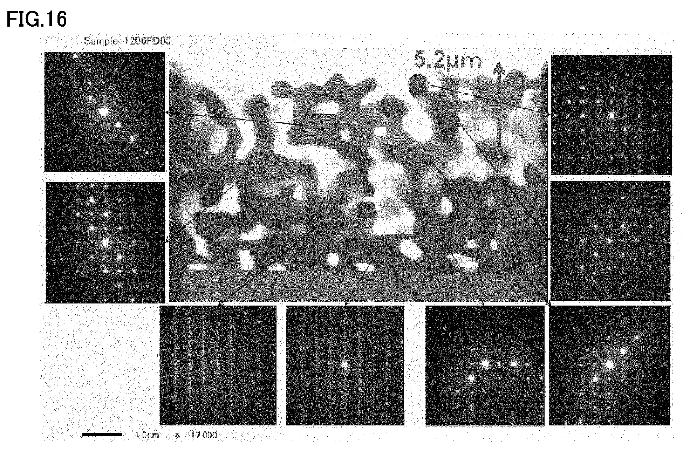

FIG. 16 shows the results of a high resolution cross-sectional TEM observation of 16-Ff-HPFC-C05. The results of the cross-sectional TEM observation image and the investigation of crystal orientations at various sites are presented.

Since the calcining process and the firing process are still on the way to optimization, control of the pores has not been achieved, but it can be seen that the film thickness reached 5.2 µm, and an a/b axial orientation is observed in the entire film. A c-axis orientation is obtained only in the vicinity of the substrate due to the nature of film formation on a LaAlO₃ substrate.

However, an oriented layer is confirmed even up to the upper part of the film. It is obvious from the model of film thickness increasing by single coating deposition, that a calcined film having many pores is likely to have cracks and is likely to be split. However, if there are fewer pores, cracks are not easily generated. These results imply that formation of a superconducting film having a thickness of 5.2 µm can be achieved by the TFA-MOD method by means of single coating deposition.

As described above, according to Examples, when CF₂H-(CF₂)ₙ-COOH or HOCO-(CF₂)ₘ-COOH (wherein n and m represent positive integers) is selected as a crack preventing chemical and incorporated into the coating solution, the oxygen partial pressure at the time of calcining is adjusted to 3% or less, and the retention time at 200°C or higher is adjusted to 7 hours or less, a thick film without cracks may be obtained by single coating deposition.

The thickness of the thick film obtainable by this technology reaches up to 5.2 µm when the thick film is converted to superconductor after firing. The film obtainable this time is a film having a porosity of 20% and having a thickness of only 4.2 µm as a superconducting material. However, one of the causes for crack generation is thought to be CuO grain growth, and when the porosity approaches 0%, the possibility of destruction of bridge sections decreases. Therefore, it can be seen that this technology is a technology capable of obtaining a film having a thickness of 5.2 µm by single coating deposition.

At this time point, since film formation is carried out on a LaAlO₃ single crystal substrate, and most of the film is constituted of the a/b-axis, the superconducting properties are almost close to zero. However, it is contemplated that when the firing process is optimized on the CeO₂ intermediate layer where a c-axis orientation is preferentially formed, the superconducting properties would be improved. Furthermore, in the cross-sectional TEM, the crystal orientation of the substrate is concordant with the crystal orientation of the a/b axis-oriented grains of the upper part of the film, and thus, it has been confirmed that the orientation of the substrate is propagated to the upper part of the film, even at this film thickness. Therefore, it is contemplated that when the firing conditions are separately optimized, and film formation is carried out on the CeO₂ intermediate layer, the characteristics would be improved.

The gist of film thickness increasing by single coating technology includes, as described in the discussion on Examples, the following three points: (1) a crack preventing chemical stably exists with trifluoroacetates; (2) calcining at a low level of oxygen is carried out to suppress vigorous combustion of the crack preventing chemical at the time of calcining; and (3) calcining is carried out in a short time in order to prevent an increase in stress and crack generation caused by CuO grain growth at the bridge sections of pores. Furthermore, it is also important to (4) use a high purity coating solution, because when the coating solution contains impurities, unstable parts occur in the bridge sections, and cracks are easily generated.

When the conditions described above are satisfied, film formation and a calcining process suitable for continuous film formation process can be achieved. During the formation of a gel film from a solution, the solution is stable for at least 24 hours, and particularly substances having small carbon chains are stable for 7 days after incorporation of crack preventing chemicals. Also, it is understood that a gel film thus formed also exists in a stable mode.

### (Example 17)

A powder of each of the hydrates of Y(OCOCH₃)₃, Ba(OCOCH₃)₂ and Cu(OCOCH₃)₂ is dissolved in ion-exchanged water, and the solution is mixed with a reaction equimolar amount of CF₃COOH and stirred. The resulting mixtures are mixed together at a metal ion molar ratio of 1 : 2 : 3, and thus a mixed solution is obtained. The mixed solution thus obtained is introduced into a pear-shaped flask and is subjected to reaction and purification for 12 hours in a rotary evaporator under reduced pressure. Thus, a semitransparent blue gel or sol is obtained.

Methanol in an amount corresponding to about 100 times the weight of the gel or sol (FIG. 1-f) is added to the gel or sol thus obtained, and the mixture is completely dissolved. When the solution is subjected again to reaction and purification for 12 hours in a rotary evaporator under reduced pressure, a semitransparent blue gel or sol is obtained.

The gel or sol thus obtained is dissolved in methanol (FIG. 1-j), and the solution is diluted by using a measuring flask. Thus, a coating solution 17Cs-base at 1.52 M in terms of metal ions was obtained.

CF₂H(CF₂)₃COOH was added as a crack preventing chemical to the coating solution 17Cs-base in an amount of 15 wt% with respect to the solute of trifluoroacetates. The mixed coating solution thus obtained was referred to as 17Cs-HPFC-C05.

The mixed coating solution 17Cs-HPFC-C05 was stored in a dry atmosphere for 24 hours after the mixing of the solutions, and a gel film having a thickness of about 20 µm was formed on a CeO₂ (150nm)/YSZ single crystal substrate and a CeO₂ (70nm)/YSZ (70nm)/Y₂O₃ (70nm)/oriented Ni substrate, by a film forming method applying the principle of a screen coating method. Film formation was carried out in an environment at an air temperature of 25°C and a relative humidity of 30 RH% to 45 RH%. The gel films thus obtained were referred to as 16Gf-HPFC-C05-A and 16Gf-HPFC-C05-B, respectively.

The gel films 16Gf-HPFC-C05-Aand 16Gf-HPFC-C05-B were subjected to a heat treatment by the calcining profile described in FIG. 7. In regard to the profile described in FIG. 7, a heat treatment was carried out by a profile of a heat treatment at 200°C to 250°C for a heat treatment time of 6 h 00 m, a heat treatment at 250°C to 300°C for a time of 0 h 50 m, and a heat treatment at 300°C to 400°C for a time of 0 h 10 m. The oxygen concentration was 1 %, and the humidity was 4.2%. The calcined films thus obtained were referred to as 16Cf-HPFC-C05-A and 16Cf-HPFC-C05-B, respectively. Cracks were generated in neither of the calcined films.

The calcined films 16Cf-HPFC-C05-Aand 16Cf-HPFC-C05-B were retained for 12 hours at a maximum temperature of 800°C in the firing profile illustrated in FIG. 9 in the presence of a mixed argon gas at an oxygen partial pressure of 1,000 ppm, and were subjected to oxygen anneal at a temperature of 525°C or lower and an amount of humidification of 1.26%. Superconducting films thus obtained were referred to as 16Ff-HPFC-C05-A and 16Ff-HPFC-C05-B, respectively. This superconducting film also did not have any cracks generated therein. The film thicknesses of the superconducting films were 2.4 µm and 2.7 µm, respectively. It was found that even though film formation is carried out using different intermediate layers, substrates and the like, the technology of film thickness increasing can be applied.

The key to satisfactory film formation by the TFA-MOD method is that: (1) there is an intermediate layer (or a substrate) that does not react with hydrogen fluoride gas generated at the time of firing; and (2) the ratio between the lattice constant of the superconductor thus formed and the lattice constant of the intermediate layer is 93% to 107%, and thus it is important that the superconductor have lattice consistency. Furthermore, in the case of film formation on CeO₂, since a superconducting layer grows in a state of inclining by 45° in the in-plane direction, the lattice consistency at the value obtained by dividing the lattice constant by a square root of 2 becomes the key to the formation of an oriented superconducting layer. It is contemplated that when these conditions (1) and (2) are satisfied, film formation can be achieved in the same manner even on an intermediate layer which has been previously subjected to film formation.

When it is wished to obtain thick superconducting films stably by the TFA-MOD method, it is effective to apply the production processes of the embodiments and Examples, and thereby, thick films may be stably obtained.

While certain embodiments have been described, these embodiments have been presented by way of example only, and are not intended to limit the scope of the inventions. Indeed, the method for manufacturing an oxide superconductor described herein may be embodied in a variety of other forms; furthermore, various omissions, substitutions and changes in the form of the devices and methods described herein may be made without departing from the scope of the inventions as defined by the appended claims.

## Claims

1. A method for manufacturing an oxide superconductor, the method comprising:
preparing a coating solution containing alcohols including methanol as a solvent, the coating solution dissolving fluorocarboxylic acid salts including trifluoroacetates, the trifluoroacetates including a metal, barium and copper, the metal being selected from yttrium and lanthanoid metals, provided that cerium, praseodymium and promethium are excluded;
adding a substance of formula: CF₂H-(CF₂)ₙ-COOH or HOCO-(CF₂)ₘ-COOH, wherein n and m represent positive integers as a crack preventing chemical to the coating solution;
forming a gel film on a substrate using the coating solution having the crack preventing chemical added thereto;
forming a calcined film by calcining the gel film at an oxygen partial pressure of 3% or less in a process that is maintained at 200°C or higher for a total time of 7 hours or less; and
forming an oxide superconductor film by firing and oxygen anneal of the calcined film.

2. A method for manufacturing an oxide superconductor, the method comprising:
preparing a coating solution containing alcohols including methanol as a solvent, the coating solution dissolving fluorocarboxylic acid salts including trifluoroacetates, the trifluoroacetates including a metal, barium and copper, the metal being selected from yttrium and lanthanoid metals, provided that cerium, praseodymium and promethium are excluded;
adding a substance of formula: CF₂H-(CF₂)ₙ-COOH or HOCO-(CF₂)ₘ-COOH, wherein n and m represent positive integers, in which at least one or more of H of the carboxylic acid group (-COOH) are substituted by Y, La, Nd, Sm, Eu, Gd, Tb, Dy, Ho, Er, Tm, Yb, Ba and Cu, as a crack preventing chemical to the coating solution;
forming a gel film on a substrate using the coating solution having the crack preventing chemical added thereto;
forming a calcined film by calcining the gel film at an oxygen partial pressure of 3% or less in a process that is maintained at 200°C or higher for a total time of 7 hours or less; and
forming an oxide superconductor film by firing and oxygen anneal of the calcined film.

3. The method according to claims 1 or 2, wherein n represents 2 to 6, or m represents 2 to 5.

4. The method according to claim 2, wherein a substance of formula: CF₂H-(CF₂)ₙ-COOH or HOCO-(CF₂)ₘ-COOH is further added as a crack preventing chemical to the coating solution.

5. The method according to any preceding claim, wherein the fluorocarboxylic acid salts include trifluoroacetates at a proportion of 70 mol% or more.

6. The method according to any preceding claim, wherein the methanol occupies 80 mol% or more of the solvent.

7. The method according to any preceding claim, wherein the time taken from the adding of the crack preventing chemical to the forming of the gel film is 60 minutes or longer.

8. The method according to claim 7, wherein the time taken from the adding of the crack preventing chemical to the forming of the gel film is 24 hours or longer.

## Patentansprüche

1. Verfahren zur Herstellung eines Oxid-Supraleiters, wobei das Verfahren Folgendes umfasst:
das Herstellen einer Beschichtungslösung enthaltend Alkohole, einschließlich Methanol, als Lösungsmittel, wobei die Beschichtungslösung Fluorcarbonsäuresalze, einschließlich Trifluoracetate, löst, wobei die Trifluoracetate ein Metall, Barium und Kupfer umfassen, wobei das Metall ausgewählt wird von Yttrium- und Lanthanoidmetallen, vorausgesetzt, dass Cer, Praseodym und Promethium ausgeschlossen sind;
das Zugeben einer Substanz der Formel: CF₂H-(CF₂)ₙ-COOH oder HOCO-( CF₂)ₘCOOH, wobei n und m positive ganze Zahlen darstellen, als rissbildungsverhindernde Chemikalie zu der Beschichtungslösung;
das Bilden eines Gelfilms auf einem Substrat unter Anwendung der Beschichtungslösung, der die rissbildungsverhindernde Chemikalie zugegeben worden ist;
das Bilden eines calcinierten Films durch Calcinieren des Gelfilms bei einem Sauerstoffpartialdruck von 3 % oder weniger in einem Verfahren, das für eine Gesamtzeit von 7 Stunden oder weniger bei 200 °C oder höher gehalten wird; und
das Bilden einer Oxid-Supraleiterfilms durch Brennen und Sauerstofftempern des calcinierten Films.

2. Verfahren zur Herstellung eines Oxid-Supraleiters, wobei das Verfahren Folgendes umfasst:
das Herstellen einer Beschichtungslösung enthaltend Alkohole, einschließlich Methanol, als Lösungsmittel, wobei die Beschichtungslösung Fluorcarbonsäuresalze, einschließlich Trifluoracetate, löst, wobei die Trifluoracetate ein Metall, Barium und Kupfer umfassen, wobei das Metall ausgewählt wird von Yttrium- und Lanthanoidmetallen, vorausgesetzt, dass Cer, Praseodym und Promethium ausgeschlossen sind;
das Zugeben einer Substanz der Formel: CF₂H-(CF₂)ₙ-COOH oder HOCO-( CF₂)ₘCOOH, wobei n und m positive ganze Zahlen darstellen, wobei mindestens eines oder mehrere von H der Carbonsäuregruppe (-COOH) durch Y, La, Nd, Sm, Eu, Gd, Tb, Dy, Ho, Er, Tm, Yb, Ba und Cu substituiert sind, als rissbildungsverhindernde Chemikalie zu der Beschichtungslösung;
das Bilden eines Gelfilms auf einem Substrat unter Anwendung der Beschichtungslösung, der die rissbildungsverhindernde Chemikalie zugegeben worden ist;
das Bilden eines calcinierten Films durch Calcinieren des Gelfilms bei einem Sauerstoffpartialdruck von 3 % oder weniger in einem Verfahren, das für eine Gesamtzeit von 7 Stunden oder weniger bei 200 °C oder höher gehalten wird; und
das Bilden einer Oxid-Supraleiterfilms durch Brennen und Sauerstofftempern des calcinierten Films.

3. Verfahren nach den Ansprüchen 1 oder 2, wobei n 2 bis 6 darstellt oder m 2 bis 5 darstellt.

4. Verfahren nach Anspruch 2, wobei eine Substanz der Formel: CF₂H-(CF₂)ₙ-COOH oder HOCO-(CF₂)ₘCOOH ferner als rissbildungsverhindernde Chemikalie zu der Beschichtungslösung zugegeben wird.

5. Verfahren nach einem der vorhergehenden Ansprüche, wobei die Fluorcarbonsäuresalze Trifluoracetate in einem Anteil von 70 Mol-% oder mehr umfassen.

6. Verfahren nach einem der vorhergehenden Ansprüche, wobei das Methanol 80 Mol-% oder mehr des Lösungsmittels einnimmt.

7. Verfahren nach einem der vorhergehenden Ansprüche, wobei die Zeit vom Zusetzen der rissbildungsverhindernden Chemikalie bis zum Bilden des Gelfilms 60 Minuten oder länger beträgt.

8. Verfahren nach Anspruch 7, wobei die Zeit vom Zusetzen der rissbildungsverhindernden Chemikalie bis zum Bilden des Gelfilms 24 Stunden oder länger beträgt.

## Revendications

1. Procédé de fabrication d'un supraconducteur oxyde, le procédé comprenant :
la préparation d'une solution de revêtement contenant des alcools comprenant du méthanol comme solvant, la solution de revêtement dissolvant des sels d'acide fluorocarboxylique incluant les trifluoroacétates, les trifluoroacétates comprenant un métal, du baryum et du cuivre, le métal étant sélectionné parmi les métaux yttrium et lanthanoïdes, à condition que le cérium, le praséodyme et le prométhium soient exclus ;
l'ajout d'une substance de formule : CF₂H-(CF₂)ₙ-COOH ou HOCO-(CF₂)ₘ-COOH, où n et m représentent des nombres entiers positifs comme agent chimique de prévention des fissures à la solution de revêtement ;
la formation d'un film formant gel sur un substrat en utilisant la solution de revêtement ayant ajouté à l'intérieur l'agent chimique de prévention des fissures ;
la formation d'un film calciné par calcination du film formant gel à une pression partielle d'oxygène de 3 % ou moins dans un procédé qui est maintenu à 200 °C ou plus sur une durée totale de 7 heures ou moins ; et
la formation d'un film supraconducteur oxyde par calcination et recuit sous oxygène du film calciné.

2. Procédé de fabrication d'un supraconducteur oxyde, le procédé comprenant :
la préparation d'une solution de revêtement comprenant des alcools comprenant le méthanol comme solvant, la solution de revêtement dissolvant des sels d'acide fluorocarboxylique incluant les trifluoroacétates, les trifluoroacétates comprenant un métal, du baryum et du cuivre, le métal étant sélectionné parmi les métaux yttrium et lanthanoïdes, à condition que le cérium, le praséodyme et le prométhium soient exclus ;
l'ajout d'une substance de formule : CF₂H-(CF₂)ₙ-COOH ou HOCO-(CF₂)ₘ-COOH, où n et m représentent des nombres entiers positifs, dans lesquels au moins un H ou plus du groupe acide carboxylique (-COOH) sont substitués par Y, La, Nd, Sm, Eu, Gd, Tb, Dy, Ho, Er, Tm, Yb, Ba et Cu, comme agent chimique de prévention des fissures à la solution de revêtement ;
la formation d'un film formant gel sur un substrat en utilisant la solution de revêtement ayant ajouté à l'intérieur l'agent chimique de prévention des fissures ;
la formation d'un film calciné par calcination du film formant gel à une pression partielle d'oxygène de 3 % ou moins dans un procédé qui est maintenu à 200 °C ou plus sur une durée totale de 7 heures ou moins ; et
la formation d'un film supraconducteur oxyde par calcination et recuit sous oxygène du film calciné.

3. Procédé selon les revendications 1 ou 2, où n représente 2 à 6, ou m représente 2 à 5.

4. Procédé selon la revendication 2, où une substance de formule : CF₂H-(CF₂)ₙ-COOH ou HOCO-(CF₂)ₘ-COOH est en outre ajoutée comme agent chimique de prévention des fissures à la solution de revêtement.

5. Procédé selon l'une quelconque des revendications précédentes, où les sels d'acide fluorocarboxylique comprennent des trifluoroacétates en une proportion de 70 % en moles ou plus.

6. Procédé selon l'une quelconque des revendications précédentes, où le méthanol occupe 80 % en moles ou plus du solvant.

7. Procédé selon l'une quelconque des revendications précédentes, où le temps consacré à partir de l'addition de l'agent chimique de prévention des fissures jusqu'à la formation du film formant gel est de 60 minutes ou plus.

8. Procédé selon la revendication 7, où le temps pris à partir de l'addition de l'agent chimique de prévention des fissures jusqu'à la formation du film formant gel est de 24 heures ou plus.
